# EUROPEAN PATENT APPLICATION

(11) **EP 4 378 682 A1**
(43) Date of publication of application: **05.06.2024**
(21) Application number: 22849585.9
(22) Date of filing: 28.07.2022
(51) Int. Cl.: B32B 25/14, B32B 27/30, C08K 5/00, C08K 5/01, C08L 9/06, C08L 23/00, C08L 23/08, C08L 25/08, C08L 33/04, C08L 53/02, C08K 3/18, H05K 1/03

(54) **RESIN COMPOSITION, RESIN SHEET, MULTILAYER BODY, SHEET CURED PRODUCT, AND CIRCUIT BOARD MATERIAL**

(30) Priority: 28.07.2021 JP 2021123106; 29.07.2021 JP 2021124084; 27.07.2022 JP 2022119506; 27.07.2022 JP 2022119507; 27.07.2022 JP 2022119508
(71) Applicant: Mitsubishi Chemical Corporation, Chiyoda-ku Tokyo 100-8251 (JP)
(72) Inventor: USHIJIMA Mayuka, Tokyo 100-8251 (JP); HAYAKAWA Yuuko, Tokyo 100-8251 (JP)
(74) Representative: Hoffmann Eitle
(86) International application number: PCT/JP2022/029108
(87) International publication number: WO 2023/008524

(57) **Abstract**

A resin composition according to one aspect of the present invention contains at least one thermoplastic resin (A1) selected from the group consisting of a styrene-based thermoplastic elastomer, an olefin-based thermoplastic elastomer, and an ethylene-based polymer and a vinyl-based crosslinking agent (B1) having a mass-average molecular weight (Mw) of 100 or more and 4,000 or less, in which a content of the vinyl-based crosslinking agent (B1) is 1 part by mass or more and less than 30 parts by mass with respect to 100 parts by mass of the thermoplastic resin (A). A resin sheet according to another aspect of the present invention is formed of the resin composition. In addition, a multilayer body according to another aspect of the present invention includes the resin sheet and a release film provided on one or both surfaces of the resin sheet.

## Description

### [Technical Field]

The present invention relates to a resin composition, a resin sheet, a multilayer body, a sheet cured product, and a circuit board material.

Priority is claimed on Japanese Patent Application No. 2021-123106, filed July 28, 2021, Japanese Patent Application No. 2021-124084, filed July 29, 2021, and Japanese Patent Application No. 2022-119506, Japanese Patent Application No. 2022-119507, and Japanese Patent Application No. 2022-119508, filed July 27, 2022, the contents of which are incorporated herein by reference.

### [Background Art]

In recent years, with higher performance and higher functionality of electrical and electronic equipment, communication frequency has been increased in order to improve communication speed and amount of information transmission.

In a case where a digital transmittance flows through a circuit substrate, a part of the transmitted digital signals are thermally converted in the circuit substrate, which causes a transmission loss. Since amount of transmission loss is expressed by a product of a specific dielectric constant and a dielectric tangent, a material having a low specific dielectric constant and a low dielectric tangent, that is, a member having low dielectric characteristics has been required in order to achieve low transmission loss. Particularly, in a high-frequency region, since a transmission signal has a characteristic that is more easily converted into heat, a material having lower dielectric characteristics has been required.

On the other hand, with higher integration of circuit in the electrical and electronic equipment, amount of heat generated inside the electrical and electronic equipment has also increased, so that a circuit board material has also been required to have heat resistance.

As the material having low dielectric characteristics, for example, thermosetting resins such as a polyphenylene ether resin composition in which an epoxy compound and a cyanate compound are blended (for example, see Patent Document 1) and a maleimide resin (for example, see Patent Document 2), and thermoplastic resins such as a cyclic olefin-based resin composition (for example, see Patent Document 3) has been known.

### [Citation List]

### [Patent Documents]

[Patent Document 1]
   Japanese Unexamined Patent Application, First Publication No. 2010-059363
[Patent Document 2]
   Japanese Unexamined Patent Application, First Publication No. 2012-255059
[Patent Document 3]
   PCT International Publication No. WO2006/095511

### [Summary of Invention]

### [Technical Problem]

However, the thermosetting resins in the related art tend to have a higher specific dielectric constant and a higher dielectric tangent than the thermoplastic resins, and it has been necessary to add a large amount of inorganic particles or the like in order to obtain low dielectric characteristics.

On the other hand, the thermoplastic resins in the related art have low dielectric characteristics, but may have poor heat resistance.

In addition, when the above-described material is used as the circuit board material, since the material is used by being laminated with a conductor such as a copper foil, it is required to reduce a linear thermal expansion coefficient so that peeling or deformation with the conductor does not occur.

Therefore, an object of one aspect of the present invention is to provide a sheet cured product and a circuit board material, which have low dielectric characteristics and heat resistance; and to provide a resin composition, a resin sheet, and a multilayer body, with which the sheet cured product and the circuit board material having low dielectric characteristics and heat resistance can be produced. An object of another aspect of the present invention is to provide a sheet cured product and a circuit board material, which have low dielectric characteristics and heat resistance and have a low linear thermal expansion coefficient; and to provide a resin composition, a resin sheet, and a multilayer body, with which the sheet cured product and the circuit board material having low dielectric characteristics and heat resistance and having a low linear thermal expansion coefficient can be produced.

### [Solution to Problem]

As a result of intensive studies to achieve the above-described objects, the present inventor has found that it is possible to achieve both the low dielectric characteristics and the heat resistance by adding a specific crosslinking agent to a thermoplastic resin. In addition, as a result of intensive studies to achieve the above-described objects, the present inventor has found that it is possible to achieve the low dielectric characteristics, the heat resistance, and the low linear thermal expansion coefficient by adding a specific crosslinking agent to a specific cyclic polyolefin resin copolymer and a thermoplastic resin. In addition, as a result of intensive studies to achieve the above-described objects, the present inventor has found that it is possible to achieve both the low dielectric characteristics and the heat resistance by adding a specific compound to a thermoplastic resin.

The gist of the present invention is as follows.
[1] A resin composition comprising:
   at least one thermoplastic resin (A1) selected from the group consisting of a styrene-based thermoplastic elastomer, an olefin-based thermoplastic elastomer, and an ethylene-based polymer; and
   a vinyl-based crosslinking agent (B1) having a mass-average molecular weight (Mw) of 100 or more and 4,000 or less,
   wherein a content of the vinyl-based crosslinking agent (B1) is 1 part by mass or more and less than 30 parts by mass with respect to 100 parts by mass of the thermoplastic resin (A1).
[2] The resin composition according to [1],
   wherein the thermoplastic resin (A1) includes the styrene-based thermoplastic elastomer.
[3] The resin composition according to [1] or [2],
   wherein a styrene content of the styrene-based thermoplastic elastomer is 10% by mass or more and 70% by mass or less.
[4] The resin composition according to any one of [1] to [3],
   wherein the vinyl-based crosslinking agent (B1) includes at least one selected from the group consisting of a monofunctional aliphatic (meth)acrylate compound, a difunctional aromatic vinyl compound, and a trialkenyl isocyanurate compound.
[5] The resin composition according to any one of [1] to [4],
   wherein the vinyl-based crosslinking agent (B1) has no polar functional group in a molecule.
[6] The resin composition according to any one of [1] to [5],
   wherein a polar functional group equivalent of the vinyl-based crosslinking agent (B1) (a molecular weight of the vinyl-based crosslinking agent (Bl)/a molecular weight of a polar functional group) is 2 or more.
[7] The resin composition according to any one of [1] to [6], further comprising:
   inorganic particles or organic particles.
[8] A resin sheet formed of the resin composition according to any one of [1] to [7].
[9] A multilayer body comprising:
   the resin sheet according to [8]; and
   a release film provided one or both surfaces of the resin sheet.
[10] A sheet cured product obtained by curing the resin sheet according to [8].
[11] A circuit board material comprising:
   an insulating layer consisting of the resin sheet according to [8]; and
   a conductor laminated on the insulating layer.
[12] A resin sheet formed of a resin composition containing at least one thermoplastic resin (A1) selected from the group consisting of a styrene-based thermoplastic elastomer, an olefin-based thermoplastic elastomer, and an ethylene-based polymer, and a vinyl-based crosslinking agent (B1),
   wherein a dielectric tangent of a cured product which is obtained by heat-pressing the resin sheet under conditions of 200°C and 0.2 MPa for 30 minutes is 0.003 or less, and
   a storage elastic modulus of the cured product (at 200°C) is 0.01 MPa or more.
[13] The resin sheet according to [12],
   wherein the vinyl-based crosslinking agent (B1) is contained in an amount of 1 part by mass or more and less than 30 parts by mass with respect to 100 parts by mass of the thermoplastic resin (A1).
[14] The resin sheet according to [12] or [13],
   wherein a content of the thermoplastic resin (A1) in resin components of the resin composition is 60% by mass or more.
[15] A resin composition comprising:
   a cyclic polyolefin resin copolymer (A2) having a crystal melting peak temperature of lower than 100°C;
   at least one thermoplastic resin (B2) selected from the group consisting of a styrene-based thermoplastic elastomer, an olefin-based thermoplastic elastomer, and an ethylene-based polymer; and
   a vinyl-based crosslinking agent (C2).
[16] The resin composition according to [15],
   wherein the cyclic polyolefin resin copolymer (A2) has cyclohexane in a side chain of a polyolefin.
[17] The resin composition according to [15] or [16],
   wherein the cyclic polyolefin resin copolymer (A2) is a resin copolymer including at least one hydrogenated aromatic vinyl polymer block unit and at least one hydrogenated conjugated diene polymer block unit, or a modified product of the resin copolymer with at least one of an unsaturated carboxylic acid or an anhydride of the unsaturated carboxylic acid.
[18] The resin composition according to [17],
   wherein a hydrogenation level of the hydrogenated aromatic vinyl polymer block unit is 90% or more.
[19] The resin composition according to [17] or [18],
   wherein a hydrogenation level of the hydrogenated conjugated diene polymer block unit is 95% or more.
[20] The resin composition according to any one of [15] to [19],
   wherein the thermoplastic resin (B2) includes the styrene-based thermoplastic elastomer.
[21] The resin composition according to any one of [15] to [20],
   wherein a styrene content of the styrene-based thermoplastic elastomer is 10% by mass or more and 70% by mass or less.
[22] The resin composition according to any one of [15] to [21],
   wherein the vinyl-based crosslinking agent (C2) includes at least one selected from the group consisting of a monofunctional aliphatic (meth)acrylate compound, a difunctional aromatic vinyl compound, and a trialkenyl isocyanurate compound.
[23] The resin composition according to any one of [15] to [22],
   wherein the vinyl-based crosslinking agent (C2) has no polar functional group in a molecule.
[24] The resin composition according to any one of [15] to [23],
   wherein a polar functional group equivalent of the vinyl-based crosslinking agent (C2) (a molecular weight of the vinyl-based crosslinking agent (C2)/a molecular weight of a polar functional group) is 2 or more.
[25] A resin sheet formed of the resin composition according to any one of [15] to [24].
[26] A multilayer body comprising:
   the resin sheet according to [25]; and
   a release film provided one or both surfaces of the resin sheet.
[27] A sheet cured product obtained by curing the resin sheet according to [25].
[28] A circuit board material comprising:
   an insulating layer consisting of the resin sheet according to [25]; and
   a conductor laminated on the insulating layer.
[29] A resin composition comprising:
   at least one thermoplastic resin (A3) selected from the group consisting of a styrene-based thermoplastic elastomer, an olefin-based thermoplastic elastomer, and an ethylene-based polymer;
   a monofunctional (meth)acrylate (B3) having a long chain alkyl group; and
   a polyfunctional (meth)acrylate (C3),
   wherein a total content of the monofunctional (meth)acrylate (B3) and the polyfunctional (meth)acrylate (C3) is 1 part by mass or more and less than 30 parts by mass with respect to 100 parts by mass of the thermoplastic resin (A3).
[30] The resin composition according to [29],
   wherein the thermoplastic resin (A3) includes the styrene-based thermoplastic elastomer.
[31] The resin composition according to [29] or [30],
   wherein a styrene content of the styrene-based thermoplastic elastomer is 10% by mass or more and 70% by mass or less.
[32] The resin composition according to any one of [29] to [31],
   wherein a mass ratio (B3):(C3) of the monofunctional (meth)acrylate (B3) having a long chain alkyl group and the polyfunctional (meth)acrylate (C3) is 50:50 to 99:1.
[33] The resin composition according to any one of [29] to [32],
   wherein a polar functional group equivalent of the monofunctional (meth)acrylate (B3) having a long chain alkyl group (a molecular weight of the monofunctional (meth)acrylate (B3) having a long chain alkyl group/a molecular weight of a polar functional group) is 2 or more.
[34] The resin composition according to any one of [29] to [33],
   wherein a polar functional group equivalent of the polyfunctional (meth)acrylate (C3) (a molecular weight of the polyfunctional (meth)acrylate (C3)/a molecular weight of a polar functional group) is 1.5 or more.
[35] A resin sheet formed of the resin composition according to any one of [29] to [34].
[36] A multilayer body comprising:
   the resin sheet according to [35]; and
   a release film provided one or both surfaces of the resin sheet.
[37] A sheet cured product obtained by curing the resin sheet according to [35].
[38] A circuit board material comprising:
   an insulating layer consisting of the resin sheet according to [35]; and
   a conductor laminated on the insulating layer.

### [Advantageous Effects of Invention]

According to one aspect of the present invention, it is to obtain a sheet cured product and a circuit board material, which have low dielectric characteristics and heat resistance; and to obtain a resin composition, a resin sheet, and a multilayer body, with which the sheet cured product and the circuit board material having low dielectric characteristics and heat resistance can be produced. According to another aspect of the present invention, it is possible to obtain a sheet cured product and a circuit board material, which have low dielectric characteristics and heat resistance and have a low linear thermal expansion coefficient; and to obtain a resin composition, a resin sheet, and a multilayer body, with which the sheet cured product and the circuit board material having low dielectric characteristics and heat resistance and having a low linear thermal expansion coefficient can be produced.

### [Description of Embodiments]

Hereinafter, embodiments of the present invention will be described in detail. However, the following description is an example of the embodiments of the present invention, and the present invention is not limited to the following description content as long as it does not exceed the gist of the present invention.

When the expression "to" is used below, it is used as an expression including numerical values or physical property values before and after "to".

### [First embodiment]

### <Resin composition>

The resin composition according to one embodiment of the present invention (hereinafter, also referred to as "present composition (1)") contains at least one thermoplastic resin (A1) selected from the group consisting of a styrene-based thermoplastic elastomer, an olefin-based thermoplastic elastomer, and an ethylene-based polymer, and a vinyl-based crosslinking agent (B1).

The reason why heat resistance of a sheet cured product and a circuit board material, including the present composition (1), is favorable is not clear, but it is considered that this is because, in a case where the present composition (1) is cured, the vinyl-based crosslinking agent (B1) entangled with the thermoplastic resin (A1) increases a pseudo-crosslinking density, which improves elastic modulus.

Hereinafter, each component of the present composition (1) will be described.

### 1. Thermoplastic resin (A1)

The thermoplastic resin (A1) of the present composition (1) is at least one selected from the group consisting of a styrene-based thermoplastic elastomer, an olefin-based thermoplastic elastomer, and an ethylene-based polymer.

As the above-described styrene-based thermoplastic elastomer, for example, a styrene-butadiene-styrene block copolymer (SBS), a styrene-isoprene-styrene block copolymer (SIS), a styrene-ethylene-butadiene-styrene block copolymer (SEBS), a styrene-ethylene-propylene-styrene block copolymer (SEPS), a styrene-isobutylene-styrene block copolymer (SIBS), which are obtained by hydrogenating the copolymers, and the like are exemplary examples.

The above-described olefin-based thermoplastic elastomer includes a polyolefin as a hard segment and includes a rubber component as a soft segment.

The above-described olefin-based thermoplastic elastomer may be a mixture (polymer blend) of polyolefin and a rubber component, a crosslinked product obtained by subjecting polyolefin and a rubber component to a crosslinking reaction, or a polymer obtained by polymerizing polyolefin and a rubber component.

As the above-described polyolefin, polypropylene, polyethylene, and the like are exemplary examples.

As the above-described rubber component, diene-based rubbers such as isoprene rubber, butadiene rubber, butyl rubber, propylene-butadiene rubber, acrylonitrile-butadiene rubber, and acrylonitrile-isoprene rubber, ethylene-propylene non-conjugated diene rubber, ethylene-butadiene copolymer rubber, and the like are exemplary examples.

As the above-described ethylene-based polymer, a homopolymer of ethylene, a copolymer of ethylene with other monomers, and the like are exemplary examples.

The above-described copolymer of ethylene with other monomers preferably includes ethylene as a main component. Here, the "including ethylene as a main component" means that an ethylene structural unit in the copolymer is contained in an amount of 50 mol% or more, preferably 60 mol% or more.

In addition, the other monomers copolymerized with the ethylene are not particularly limited as long as the monomers are copolymerizable with the ethylene.

As a preferred example of the above-described ethylene-based polymer, low-density polyethylene (LDPE), linear low-density polyethylene (LLDPE), a polyethylene obtained by a polymerization using a metallocene catalyst, and the like are exemplary examples. Among these, from the viewpoint of high flexibility, it is particularly preferable to use linear low-density polyethylene (LLDPE).

Among the above-mentioned thermoplastic resins (A1), from the viewpoint of low dielectric characteristics and ease of processability, the styrene-based thermoplastic elastomer is preferable, and the styrene-ethylene-butadiene-styrene block copolymer (SEBS) is more preferable.

In addition, among the thermoplastic resins (A1) mentioned above, in particular, when a combination in which the thermoplastic resin (A1) itself is difficult to react with the vinyl-based crosslinking agent (B1) is selected, it is considered that the thermoplastic resin (A1) and the vinyl-based crosslinking agent (B1) form an interpenetrating polymer network structure (hereinafter, also referred to as "semi-IPN structure"), which improves the low dielectric characteristics and the heat resistance. The semi-IPN structure is a structure in which, rather than forming a chemical bond between the thermoplastic resin (A1) and the vinyl-based crosslinking agent (B1), molecular chains of the thermoplastic resin (A1) and molecular chains of the vinyl-based crosslinking agent (B1) are partially and physically entangled with each other. By forming the semi-IPN structure, while maintaining the low dielectric characteristics of the thermoplastic resin (A1), the pseudo-crosslinking density is higher as compared with the thermoplastic resin (A1) alone. Therefore, it is considered that the elastic modulus is improved and the heat resistance is favorable. From this viewpoint, among the above-mentioned thermoplastic resins (A1), the styrene-based thermoplastic elastomer is preferable; a styrene-isobutylene-styrene block copolymer (SIBS) or a styrene-ethylene-butadiene-styrene block copolymer (SEBS) is more preferable; and a styrene-ethylene-butadiene-styrene block copolymer (SEBS) is still more preferable.

When the styrene-based thermoplastic elastomer is used as the thermoplastic resin (A1), a styrene content is preferably 10% by mass or more and more preferably 15% by mass or more. In addition, the styrene content is preferably 70% by mass or less, more preferably 60% by mass or less, still more preferably 50% by mass or less, and even more preferably 40% by mass or less.

In a case where the styrene content is within the above-described range, the dielectric tangent of the thermoplastic resin (A1) is low and the elastic modulus is also an appropriate value, so that it is possible to achieve both the low dielectric characteristics and the heat resistance, and handleability is also favorable.

The thermoplastic resin (A1) may be modified by a known method. As the modified product, for example, a reaction product between the thermoplastic resin (A1) mentioned above and at least one of an unsaturated carboxylic acid or an anhydride thereof is an exemplary example.

By modifying the thermoplastic resin (A1), polarity of the polymer is increased, so that improvement of adhesiveness to a metal layer such as a copper foil can be expected.

As the above-described at least one of the unsaturated carboxylic acid or the anhydride thereof, for example, unsaturated carboxylic acids such as acrylic acid, methacrylic acid, α-ethyl acrylic acid, maleic acid, fumaric acid, tetrahydrophthalic acid, methyltetrahydrophthalic acid, itaconic acid, citraconic acid, crotonic acid, isocrotonic acid, and nadic acids; and anhydrides thereof are exemplary examples.

In addition, as the acid anhydride, specifically, maleic acid anhydride, citraconic acid anhydride, and nadic acid anhydrides are exemplary examples.

As the nadic acids or anhydrides thereof, endocis-bicyclo[2.2.1]hept-2,3-dicarboxylic acid (nadic acid), methyl-endocis-bicyclo[2.2.1]hept-5-ene-2,3-dicarboxylic acid (methyl nadic acid), and anhydrides thereof are exemplary examples.

Among at least one of these unsaturated carboxylic acids or anhydrides thereof, acrylic acid, maleic acid, nadic acid, maleic acid anhydride, or nadic acid anhydride is preferable.

The at least one of an unsaturated carboxylic acid or an anhydride thereof can be used alone or in combination of two or more thereof.

From the viewpoint of low dielectric characteristics, a content of the thermoplastic resin (A1) in the present composition (1) in resin components of the present composition (1) is preferably 60% by mass or more, more preferably 70% by mass or more, still more preferably 80% by mass or more, and even more preferably 85% by mass or more. The upper limit of the above-described content is not particularly limited, and the resin components of the present composition (1) may be only the thermoplastic resin (A1) (100% by mass).

In the present invention, the "resin components" refer to the thermoplastic resin (A) contained in the present composition (1) and other resins added as necessary.

A storage elastic modulus of the thermoplastic resin (A1) at 24°C is preferably 0.1 MPa or more and more preferably 1 MPa or more. In addition, the above-described storage elastic modulus is preferably less than 2,000 MPa, more preferably less than 1,500 MPa, still more preferably less than 1,000 MPa, even more preferably less than 500 MPa, even still more preferably less than 300 MPa, still further preferably less than 100 MPa, and even further preferably less than 50 MPa.

By setting the storage elastic modulus to be less than the above-described upper limit value, flexibility of a sheet cured product to be obtained is favorable. In addition, by setting the storage elastic modulus to be the above-described lower limit value or more, heat resistance and handleability of the sheet cured product to be obtained are favorable.

The above-described storage elastic modulus is a value obtained by molding the thermoplastic resin (A1) into a sheet shape having a thickness of 300 µm to obtain a test piece, and measuring a dynamic viscoelasticity with a viscoelastic spectrometer. Measurement conditions may be the same as conditions described in Examples.

A density of the thermoplastic resin (A1) is preferably 0.98 g/cm³ or less, more preferably 0.95 g/cm³ or less, and still more preferably 0.91 g/cm³ or less. On the other hand, the lower limit of the above-described density is not particularly limited, but is preferably 0.80 g/cm³ or more.

By setting the density to be the above-described value or less, flexibility of a sheet cured product to be obtained is favorable.

The above-described density can be measured by molding the thermoplastic resin (A1) into a sheet shape having a thickness of 300 µm to obtain a test piece, and measuring a density in accordance with ASTM D792.

A dielectric tangent of the thermoplastic resin (A1) at 10 GHz is preferably less than 0.003, more preferably less than 0.002, and still more preferably less than 0.001. On the other hand, the lower limit thereof is not particularly limited, and may be 0 or more.

As the dielectric tangent is smaller, dielectric loss is smaller, and thus efficiency and high speed of transmission of electrical signals in a case where the present composition (1) is used as a circuit board material are obtained.

The above-described dielectric tangent is a value obtained by molding the thermoplastic resin (A1) into a sheet shape having a thickness of 300 µm to obtain a test piece, and measuring a dielectric tangent in accordance with JIS C2565:1992 under conditions of a temperature of 23°C and a frequency of 10 GHz.

### 2. Vinyl-based crosslinking agent (B1)

The vinyl-based crosslinking agent (B1) of the present composition (1) preferably has a mass-average molecular weight (Mw) of 100 or more and 4,000 or less.

The above-described mass-average molecular weight (Mw) is preferably 120 or more. In addition, the above-described mass-average molecular weight (Mw) is preferably 3,000 or less, more preferably 2,000 or less, still more preferably 1,000 or less, even more preferably 800 or less, and even still more preferably 600 or less.

Since the mass-average molecular weight (Mw) of the vinyl-based crosslinking agent (B1) is within the above-described range, the molecular chains of the thermoplastic resin (A1) and the molecular chains of the vinyl-based crosslinking agent (B1) are easily entangled with each other during curing, and the pseudo-crosslinking density is easily increased, so that the heat resistance of the sheet cured product to be obtained is favorable.

When the crosslinking agent is a partially crosslinked substance or is not a polymer, the "mass-average molecular weight (Mw) of the vinyl-based crosslinking agent (B1)" means a molecular weight of a compound used as the vinyl-based crosslinking agent (B1).

The vinyl-based crosslinking agent (B1) is a crosslinking agent having a vinyl group in the molecule, and also includes a crosslinking agent having an acryl group or a methacrylic group in the molecule. The vinyl-based crosslinking agent (B1) may be any of monofunctional, difunctional, or polyfunctional such as tri- or higher functional.

As the a monofunctional vinyl-based crosslinking agent (B1), for example, monofunctional aliphatic (meth)acrylate compounds such as isooctyl (meth)acrylate, isononyl (meth)acrylate, isodecyl (meth)acrylate, lauryl (meth)acrylate, tridecyl (meth)acrylate, stearyl acrylate, and isostearyl acrylate are exemplary examples.

As a difunctional vinyl-based crosslinking agent (B1), difunctional aromatic vinyl compounds such as divinylbenzene, divinylnaphthalene, and divinylbiphenyl; difunctional aliphatic (meth)acrylate compounds such as ethylene glycol di(meth)acrylate, diethylene glycol di(meth)acrylate, triethylene glycol di(meth)acrylate, tetraethylene glycol di(meth)acrylate, polyethylene glycol di(meth)acrylate, propylene glycol di(meth)acrylate, dipropylene glycol di(meth)acrylate, tripropylene glycol di(meth)acrylate, tetrapropylene glycol di(meth)acrylate, polypropylene glycol di(meth)acrylate, ethoxylated polypropylene glycol di(meth)acrylate, 1,3-butanediol di(meth)acrylate, 1, 4-butanediol di(meth)acrylate, neopentyl glycol di(meth)acrylate, 3-methyl-1,5-pentanediol di(meth)acrylate, 1,6-hexanediol di(meth)acrylate, 2-butyl-2-ethyl-1,3-propanediol di(meth)acrylate, 1,9-nonanediol di(meth)acrylate, 1,10-decanediol di(meth)acrylate, glycerin di(meth)acrylate, tricyclodecane dimethanol di(meth)acrylate, and ethoxylated 2-methyl-1,3-propanediol di(meth)acrylate; difunctional alicyclic (meth)acrylate compounds such as cyclohexane dimethanol di(meth)acrylate, ethoxylated cyclohexane dimethanol di(meth)acrylate, propoxylated cyclohexane dimethanol di(meth)acrylate, ethoxylated and propoxylated cyclohexane dimethanol di(meth)acrylate, tricyclodecane dimethanol di(meth)acrylate, ethoxylated tricyclodecane dimethanol di(meth)acrylate, propoxylated tricyclodecane dimethanol di(meth)acrylate, ethoxylated and propoxylated tricyclodecane dimethanol di(meth)acrylate, ethoxylated and hydrogenated bisphenol A di(meth)acrylate, propoxylated and hydrogenated bisphenol A di(meth)acrylate, ethoxylated, propoxylated, and hydrogenated bisphenol A di(meth)acrylate, ethoxylated and hydrogenated bisphenol F di(meth)acrylate, propoxylated and hydrogenated bisphenol F di(meth)acrylate, and ethoxylated, propoxylated, and hydrogenated bisphenol F di(meth)acrylate; difunctional aromatic (meth)acrylate compounds such as ethoxylated bisphenol A di(meth)acrylate, propoxylated bisphenol A di(meth)acrylate, ethoxylated and propoxylated bisphenol A di(meth)acrylate, ethoxylated bisphenol F di(meth)acrylate, propoxylated bisphenol F di(meth)acrylate, ethoxylated and propoxylated bisphenol F di(meth)acrylate, ethoxylated bisphenol AF di(meth)acrylate, propoxylated bisphenol AF di(meth)acrylate, ethoxylated and propoxylated bisphenol AF di(meth)acrylate, ethoxylated fluorene-type di(meth)acrylate, propoxylated fluorene-type di(meth)acrylate, and ethoxylated and propoxylated fluorene-type di(meth)acrylate; difunctional heterocyclic (meth)acrylate compounds such as ethoxylated isocyanuric acid di(meth)acrylate, propoxylated isocyanuric acid di(meth)acrylate, and ethoxylated and propoxylated isocyanuric acid di(meth)acrylate; and the like are exemplary examples.

As a tri- or higher functional vinyl-based crosslinking agent (B1), trialkenyl isocyanurate compounds such as triallyl cyanurate and triallyl isocyanurate; polyfunctional aliphatic (meth)acrylate compounds such as trimethylolpropane tri(meth)acrylate, ethoxylated trimethylolpropane tri(meth)acrylate, propoxylated trimethylolpropane tri(meth)acrylate, ethoxylated and propoxylated trimethylolpropane tri(meth)acrylate, pentaerythritol tri(meth)acrylate, ethoxylated pentaerythritol tri(meth)acrylate, propoxylated pentaerythritol tri(meth)acrylate, ethoxylated and propoxylated pentaerythritol tri(meth)acrylate, pentaerythritol tetra(meth)acrylate, ethoxylated pentaerythritol tetra(meth)acrylate, propoxylated pentaerythritol tetra(meth)acrylate, ethoxylated and propoxylated pentaerythritol tetra(meth)acrylate, ditrimethylolpropane tetraacrylate, and dipentaerythritol hexa(meth)acrylate; polyfunctional heterocyclic (meth)acrylate compounds such as ethoxylated isocyanuric acid tri(meth)acrylate, propoxylated isocyanuric acid tri(meth)acrylate, and ethoxylated and propoxylated isocyanuric acid tri(meth)acrylate, and the like are exemplary examples.

Among the above, from the viewpoint of compatibility with the thermoplastic resin (A1), at least one selected from the group consisting of a monofunctional aliphatic (meth)acrylate compound, a difunctional aromatic vinyl compound, and a trialkenyl isocyanurate compound is preferable; and from the viewpoint of low dielectric characteristics, a trialkenyl isocyanurate compound is more preferable.

The monofunctional aliphatic (meth)acrylate compound preferably has an alkyl group having 8 or more and 25 or less carbon atoms. The number of carbon atoms is more preferably 10 or more, still more preferably 12 or more, and even more preferably 15 or more. In addition, the number of carbon atoms is more preferably 20 or less. Specifically, at least one selected from the group consisting of isodecyl (meth)acrylate, lauryl (meth)acrylate, tridecyl (meth)acrylate, and isostearyl acrylate is preferable, and isostearyl acrylate is more preferable. In a case where the number of carbon atoms in the alkyl group is within the above-described range, compatibility between the thermoplastic resin (A1) and the vinyl-based crosslinking agent (B1) during curing is favorable, the molecular chains thereof are easily entangled with each other, and the pseudo-crosslinking density is easily increased, so that the heat resistance of the sheet cured product to be obtained is favorable.

As the difunctional aromatic vinyl compound, divinylbenzene is preferable.

As the trialkenyl isocyanurate compound, triallyl isocyanurate is preferable.

It is preferable that the vinyl-based crosslinking agent (B1) has no polar functional group in the molecule, or has a small number of polar functional groups in the molecule. When the vinyl-based crosslinking agent (B) has a cyclic structure, it is preferable that the vinyl-based crosslinking agent (B) has no polar functional group as a substituent, or a small number of polar functional groups as a substituent.

In a case where the polar functional group is small, the compatibility with the thermoplastic resin (A1) is favorable, and the dielectric tangent of the sheet cured product to be obtained is also low.

The polar functional group means a functional group having a negative atom (for example, nitrogen, oxygen, chlorine, fluorine, and the like) and having a net dipole. For example, an ester group, a carbonyl group, a carboxyl group, a hydroxy group, an amide group, an amino group, and the like are exemplary examples.

When the vinyl-based crosslinking agent (B1) has an ester group, a polar functional group equivalent of the vinyl-based crosslinking agent (B1) (molecular weight of vinyl-based crosslinking agent (B1)/molecular weight of polar functional group (when a plurality of polar functional groups, total amount thereof)) is preferably 2 or more, more preferably 3 or more, still more preferably 4 or more, even more preferably 5 or more, and even still more preferably 6 or more.

A content of the vinyl-based crosslinking agent (B1) in the present composition (1) is 1 part by mass or more and less than 30 parts by mass with respect to 100 parts by mass of the thermoplastic resin (A1), preferably 3 parts by mass or more and 25 parts by mass or less, more preferably 5 parts by mass or more and 20 parts by mass or less, and still more preferably 10 parts by mass or more and 18 parts by mass or less.

In a case where the content of the vinyl-based crosslinking agent (B1) is within the above-described range, the compatibility with the thermoplastic resin (A1) is favorable and the pseudo-crosslinking density is easily increased, so that the heat resistance of the sheet cured product to be obtained is favorable.

### 3. Organic peroxide (C1)

The present composition (1) may contain an organic peroxide (C1) for the purpose of promoting a curing reaction.

As the above-described organic peroxide, for example, peroxides included in hydroperoxide, dialkyl peroxide, diacyl peroxide, peroxyester, and ketone peroxide groups are exemplary examples.

Specifically, hydroperoxides such as cumene hydroperoxide and tert-butyl hydroperoxide; dialkyl peroxides such as dicumyl peroxide, di-tert-butyl peroxide, 2,5-dimethyl-2,5-di(tert-butylperoxy)hexane, and 2,5-bis(tert-butylperoxy)-2,5-dimethyl -3-hexyne; diacyl peroxides such as lauryl peroxide and benzoyl peroxide; peroxyesters such as tert-butylperoxyacetate, tert-butylperoxybenzoate, and tert-butylperoxyisopropyl carbonate; and ketone peroxides such as cyclohexanone peroxide are exemplary examples.

A content of the organic peroxide (C1) in the present composition (1) is preferably 0.01 parts by mass or more and 5 parts by mass or less, more preferably 0.05 parts by mass or more and 3 parts by mass or less, and still more preferably 0.1 parts by mass or more and 1 part by mass or less with respect to 100 parts by mass of the thermoplastic resin (A1).

In a case where the content of the organic peroxide (C1) is within the above-described range, it is possible to maintain low dielectric characteristics of the sheet cured product while promoting the curing reaction.

### 4. Solvent (D1)

When the resin sheet is manufactured from the present composition (1) through a coating step, the present composition (1) may contain a solvent (D1).

The solvent (D1) is not particularly limited as long as the solvent (D1) is a solvent in which the thermoplastic resin (A1) and the vinyl-based crosslinking agent (B1) are uniformly dissolved, and toluene, cyclohexane, tetrahydrofuran, xylene, and the like are exemplary examples.

The solvent (D1) preferably has a boiling point of 200°C or lower so that the solvent (D1) volatilizes in a case where the resin sheet is dried.

From the viewpoint of film forming properties, a content of the solvent (D1) in the present composition (1) is preferably 100 parts by mass or more and 500 parts by mass or less, and more preferably 200 parts by mass or more and 400 parts by mass or less with respect to 100 parts by mass of the thermoplastic resin (A1).

### 5. Other components

The present composition (1) may contain, as a component other than the above-described components, a thermoplastic elastomer other than the thermoplastic resin (A1), a crosslinking agent other than the vinyl-based crosslinking agent (B1), an ultraviolet absorber, an antistatic agent, an antioxidant, a coupling agent, a plasticizer, a flame retardant, a colorant, a dispersant, an emulsifier, a low elastic agent, a diluent, an antifoaming agent, an ion trap agent, a thickener, a leveling agent, inorganic particles, organic particles, or the like.

As the crosslinking agent other than the vinyl-based crosslinking agent (B 1), for example, a bismaleimide compound, an epoxy compound, and the like are exemplary examples.

As the inorganic particles, for example, calcium carbonate, magnesium carbonate, barium carbonate, magnesium sulfate, barium sulfate, calcium sulfate, zinc oxide, magnesium oxide, calcium oxide, titanium oxide, aluminum oxide, alumina, aluminum hydroxide, hydroxyapatite, silica, magnesium silicate, mica, talc, kaolin, clay, glass powder, asbestos powder, zeolite, white silica, and the like are exemplary examples.

As the organic particles, for example, (meth)acrylate-based resin particles, styrene-based resin particles, silicone-based resin particles, nylon-based resin particles, polyethylene-based resin particles, benzoguanamine-based resin particles, urethane-based resin particles, and the like are exemplary examples.

When containing inorganic particles or organic particles, a content thereof is preferably 1 part by mass or more and 80 parts by mass or less, more preferably 5 parts by mass or more and 75 parts by mass or less, and still more preferably 10 parts by mass or more and 70 parts by mass or less with respect to 100 parts by mass of resin components of the present composition (1). When the content of the inorganic particles or the organic particles is the above-described lower limit value or more, the dielectric characteristics of the sheet cured product can be further lowered, the linear thermal expansion coefficient of the sheet cured product can be reduced, and when used as a circuit board material, peeling from a substrate is less likely to occur. On the other hand, in a case where the content of the inorganic particles or the organic particles is the above-described upper limit value or less, moldability of the sheet cured product is favorable.

### 6. Suitable aspects

As a combination of the thermoplastic resin (A1) and the vinyl-based crosslinking agent (B1) in the present composition (1), a combination of the styrene-based thermoplastic elastomer and at least one selected from the group consisting of a monofunctional aliphatic (meth)acrylate compound, a difunctional aromatic vinyl compound, and a trialkenyl isocyanurate compound is preferable; a combination of a styrene-isobutylene-styrene block copolymer (SIBS) or a styrene-ethylene-butadiene-styrene block copolymer (SEBS) and at least one selected from the group consisting of a monofunctional aliphatic (meth)acrylate compound, a difunctional aromatic vinyl compound, and a trialkenyl isocyanurate compound is more preferable; and a combination of a styrene-ethylene-butadiene-styrene block copolymer (SEBS) and at least one selected from the group consisting of a monofunctional aliphatic (meth)acrylate compound, a difunctional aromatic vinyl compound, and a trialkenyl isocyanurate compound is still more preferable. In addition, a combination of the styrene-based thermoplastic elastomer and the trialkenyl isocyanurate compound is preferable; a combination of a styrene-isobutylene-styrene block copolymer (SIBS) or a styrene-ethylene-butadiene-styrene block copolymer (SEBS) and the trialkenyl isocyanurate compound is more preferable; and a combination of a styrene-ethylene-butadiene-styrene block copolymer (SEBS) and the trialkenyl isocyanurate compound is particularly preferable.

### <Resin sheet>

The resin sheet according to one embodiment of the present invention (hereinafter, also referred to as "present resin sheet (1)") is obtained by molding the present composition (1) into a sheet shape in an uncured state.

A thickness of the present resin sheet (1) after curing is preferably 10 to 500 µm, more preferably 50 to 400 µm, and still more preferably 100 to 350 µm.

By setting the thickness of the present resin sheet (1) after curing to be the above-described lower limit value or more, handleability is favorable. In addition, by setting the above-described thickness to be the above-described upper limit value or less, followability to steps of a substrate is favorable when the present resin sheet (1) is used as a circuit board material.

The above-described thickness is a value obtained by heat-pressing the present resin sheet (1) under conditions of 200°C and 0.2 MPa for 30 minutes to obtain a cured product, and measuring a thickness of the obtained cured product with a micrometer.

A specific dielectric constant of the present resin sheet (1) after curing is preferably 4 or less, more preferably 3 or less, and still more preferably 2.5 or less. On the other hand, the lower limit of the above-described specific dielectric constant is not particularly limited, and may be 1 or more.

In addition, a dielectric tangent of the present resin sheet (1) after curing is preferably 0.003 or less, more preferably 0.002 or less, and still more preferably 0.0015 or less. On the other hand, the lower limit of the above-described dielectric tangent is not particularly limited, and may be 0 or more.

The above-described specific dielectric constant and dielectric tangent are values obtained by heat-pressing the present resin sheet (1) under conditions of 200°C and 0.2 MPa for 30 minutes to obtain a cured product as a test piece, and measuring a specific dielectric constant and a dielectric tangent thereof in accordance with JIS C2565:1992 under conditions of a temperature of 23°C and a frequency of 10 GHz.

From the viewpoint of handleability, a storage elastic modulus of the present resin sheet (1) after curing (at 24°C) is preferably 1 MPa or more, more preferably 2 MPa or more, and still more preferably 3 MPa or more. In addition, when the present resin sheet (1) is used as a circuit board material, from the viewpoint of followability to steps of a substrate, the above-described storage elastic modulus (24°C) is preferably 1,000 MPa or less, more preferably 500 MPa or less, and still more preferably 300 MPa or less.

From the viewpoint of heat resistance, a storage elastic modulus of the present resin sheet (1) after curing (200°C) is preferably 0.01 MPa or more, more preferably 0.05 MPa or more, and still more preferably 0.1 MPa or more. The upper limit of the above-described storage elastic modulus (200°C) is not particularly limited, but is preferably 10 MPa or less and more preferably 5 MPa or less.

The above-described storage elastic modulus is a value obtained by heat-pressing the present resin sheet (1) under conditions of 200°C and 0.2 MPa for 30 minutes to obtain a cured product as a test piece, and measuring a dynamic viscoelasticity thereof.

From the viewpoint of heat resistance in a case of being mounted on a device, a heat resistance temperature of the present resin sheet (1) after curing is preferably 200°C or higher and 500°C or lower.

The above-described heat resistance temperature is a value obtained by heat-pressing the present resin sheet (1) under conditions of 200°C and 0.2 MPa for 30 minutes to obtain a cured product as a test piece, obtaining a graph by measuring a dynamic viscoelasticity thereof, and reading a temperature immediately before a rubbery flat region changes to a viscous liquid state.

### <Multilayer body>

In order to improve handleability, the present resin sheet (1) is preferably formed into a multilayer body by providing a release film on one or both surfaces thereof.

As the release film, for example, polyolefins such as polyethylene and polypropylene; polyesters such as polyethylene terephthalate and polyethylene naphthalate; polyimides; or resin films containing polycarbonate or the like as a main component can be used. A peel strength may be adjusted by coating surfaces of these films with a silicone resin release agent or the like.

A thickness of the release film is preferably 1 to 300 µm, more preferably 5 to 200 µm, still more preferably 10 to 150 µm, and even more preferably 20 to 120 µm.

In the release film, a surface which is brought into contact with the present resin sheet (1) may be subjected to a mat treatment, a corona treatment, or an antistatic treatment.

The above-described multilayer body may be wound around a core to form a wound body.

In the wound body according to the embodiment of the present invention, a length of the multilayer body is preferably 10 m or more and more preferably 20 m or more. By setting the length of the multilayer body to be 10 m or more, for example, when the present resin sheet (1) is used as a flexible laminated plate or a stretchable laminated plate, it is possible to continuously produce electronic components, resulting in excellent continuous film forming properties. The upper limit of the above-described length is not particularly limited, but is preferably 1,000 m or less.

A material of the core is not particularly limited, and for example, paper, resin-impregnated paper, an acrylonitrile/butadiene/styrene copolymer (ABS resin), a fiber-reinforced plastic (FRP), a phenol resin, an inorganic substance-containing resin, and the like are exemplary examples. An adhesive may be used for the core.

### <Manufacturing method of resin sheet (1)>

Hereinafter, a manufacturing method of the present resin sheet (1) will be described, but the manufacturing method of the present resin sheet (1) is not limited to the following manufacturing method.

### [First manufacturing method]

A first manufacturing method of the present resin sheet (1) includes a coating liquid preparing step of preparing a coating liquid containing the resin composition, and a molding step of molding the coating liquid into a sheet shape.

### (1) Coating liquid preparing step

In the coating liquid preparing step, a coating liquid is obtained by stirring and uniformly mixing the thermoplastic resin (A1), the vinyl-based crosslinking agent (B1), and the organic peroxide (C1), the solvent (D1), and other components, which are added as necessary.

For the mixing, for example, a general mixing and stirring device such as a mixer, a blender, a three-roll kneading device, a ball mill, a kneader, a single-screw kneader, and a twin-screw kneader can be used, and during the mixing, heating may be performed as necessary.

### (2) Molding step

In the molding step, the above-described coating liquid is molded into a sheet shape to obtain a resin sheet.

As a method for molding the above-described coating liquid into a sheet shape, a known method can be used. For example, a method such as a doctor blade method, a solvent casting method, and an extrusion film formation method may be used. As a preferred molding method, a method including the following (2-1) coating step and (2-2) drying step is an exemplary example.

### (2-1) Coating step

In the coating step, a surface of the release film is coated with the coating liquid to form a coating film.

The coating method may be a general method such as a dip method, a spin coating method, a spray coating method, and a blade method. A coating device such as a spin coater, a slit coater, a die coater, or a blade coater can be used for the coating, and as a result, it is possible to uniformly form a coating film having a predetermined thickness on the release film.

### (2-2) Drying step

In the drying step, the solvent is removed from the coating film formed as described above.

A drying temperature is not particularly limited, but is usually 10°C to 150°C, preferably 25°C to 120°C and more preferably 30°C to 110°C. In a case where the drying temperature is the above-described upper limit value or lower, the crosslinking reaction of the vinyl-based crosslinking agent (B1) in the coating film is suppressed. In addition, in a case where the drying temperature is the above-described lower limit value or higher, foaming of the resin sheet can be suppressed, the solvent can be effectively removed, and productivity is improved.

A drying time can be appropriately adjusted depending on a state of the coating film, the drying environment, and the like. The drying time is preferably 1 minute or more, more preferably 2 minutes or more, still more preferably 5 minutes or more, even more preferably 10 minutes or more, particularly preferably 20 minutes or more, and most preferably 30 minutes or more. On the other hand, the drying time is preferably 4 hours or less, more preferably 3 hours or less, and still more preferably 2 hours or less.

In a case where the drying time is the above-described lower limit or more, the solvent can be sufficiently removed. In a case where the drying time is the above-described upper limit or less, the productivity can be improved and the production cost can be suppressed.

The solvent in the resin composition can be removed by a known heating method such as a hot plate, a hot air furnace, an IR heating furnace, a vacuum dryer, and a high frequency heater.

From the viewpoint of contamination prevention of the surface of the resin sheet and handleability, the release film may be laminated on the resin sheet after the above-described drying step.

### [Second manufacturing method]

A second manufacturing method of the present resin sheet (1) includes a film forming step of extruding the resin composition onto the release film.

In the film forming step, the thermoplastic resin (A1), the vinyl-based crosslinking agent (B1), and the organic peroxide (C1) and other components, which are added as necessary, are kneaded using a single-screw extruder or a twin-screw extruder, and film formation is performed by extruding the resin composition onto the release film using an extruder under a temperature condition which is a melting point of the thermoplastic resin (A1) or higher and lower than a crosslinking temperature of the vinyl-based crosslinking agent (B1). The extrusion method of the resin composition is not particularly limited, and more specifically, T-die molding is an exemplary example.

### <Sheet cured product>

The sheet cured product according to one embodiment of the present invention (hereinafter, also referred to as "present cured product (1)") is obtained by curing the present resin sheet (1).

A curing temperature of the present resin sheet (1) may be a temperature at which the thermoplastic resin (A1) does not flow and the crosslinking reaction of the vinyl-based crosslinking agent (B1) proceeds. Specifically, it is preferably 120°C to 300°C, more preferably 140°C to 250°C, and still more preferably 150°C to 220°C.

In addition, a curing time of the present resin sheet (1) is not particularly limited, but is preferably 10 minutes to 1 hour.

### <Applications of resin composition, resin sheet, and sheet cured product>

As applications of the present resin composition (1), the present resin sheet (1), and the present sheet cured product (1) according to the embodiments of the present invention, for example, copper foil laminated plates, stretchable substrates, flexible printed circuit boards, multilayer printed wiring boards, circuit board materials for electrical and electronic equipment, such as a capacitor, underfill materials, interchip fill for 3D-LSI, insulating sheets, damping materials, adhesives agents, solder resists, semiconductor encapsulants, hole filling resins, component embedding resin, and the like are exemplary examples, but the present invention is not limited thereto.

### <Circuit board material>

The present resin sheet (1) according to one embodiment of the present invention can be formed into a circuit board material by being laminated with a conductor.

As the conductor, conductive metals such as copper and aluminum, metal foils formed of alloys including these metals, or metal layers formed by plating or sputtering can be used.

When used as a circuit board material for electrical and electronic equipment, a thickness of the present resin sheet (1) is preferably 10 µm or more and 500 µm or less. In addition, a thickness of the conductor is preferably 0.2 µm or more and 70 µm or less.

### <Manufacturing method of circuit board material>

The circuit board material according to the embodiment of the present invention can be manufactured, for example, by the following method.

The present resin sheet (1) according to one embodiment of the present invention is laminated on a conductor, and the present resin sheet (1) is thermally cured to form an insulating layer. A conductor is further laminated on the insulating layer, and a necessary number of such layers is laminated.

A curing temperature of the present resin sheet (1) may be a temperature at which the thermoplastic resin (A1) does not flow and the crosslinking reaction of the vinyl-based crosslinking agent (B1) proceeds. Specifically, the curing temperature of the present resin sheet (1) is preferably 120°C to 300°C, more preferably 140°C to 250°C, and still more preferably 150°C to 220°C.

In addition, a curing time of the present resin sheet (1) is not particularly limited, but is preferably 10 minutes to 1 hour.

The laminating of the present resin sheet (1) and the conductor may be a method of directly laminating a conductive metal foil on the present resin sheet (1), or a method of adhering the resin sheet to the conductive metal foil using an adhesive. In addition, the laminating may be a method of forming a conductive metal layer by plating or sputtering, or a method of combining these methods.

In addition, the laminating may include a step of drilling the insulating layer to form a via-hole, or a step of roughing a surface of the insulating layer.

### [Second embodiment]

### <Resin composition>

The resin composition according to one embodiment of the present invention (hereinafter, also referred to as "present composition (2)") contains a cyclic polyolefin resin copolymer (A2) having a crystal melting peak temperature of lower than 100°C, at least one thermoplastic resin (B2) selected from the group consisting of a styrene-based thermoplastic elastomer, an olefin-based thermoplastic elastomer, and an ethylene-based polymer, and a vinyl-based crosslinking agent (C2).

The reason why heat resistance of a sheet cured product and a circuit board material, including the present composition (2), is favorable is not clear, but it is considered that this is because, in a case where the present composition (2) is cured, the vinyl-based crosslinking agent (C2) entangled with the cyclic polyolefin resin copolymer (A2) and the thermoplastic resin (B2) increases a pseudo-crosslinking density, which improves elastic modulus.

In addition, the reason why linear thermal expansion coefficient of the sheet cured product and the circuit board material, including the present composition (2), is lower is not clear, but the linear thermal expansion coefficient tends to be lower as an alicyclic structure is more included in the cured product. Therefore, it is considered that, by containing the cyclic polyolefin resin copolymer (A2), the alicyclic structure is relatively increased as compared with the case where the thermoplastic resin (B2) is used alone.

Hereinafter, each component of the present composition (2) will be described.

### 1. Cyclic polyolefin resin copolymer (A2)

From the viewpoint of lowering the linear thermal expansion coefficient of the sheet cured product, a content of the cyclic polyolefin resin copolymer (A2) of the present composition (2) is preferably 10% by mass or more, more preferably 15% by mass or more, and still more preferably 20% by mass or more in resin components of the present composition (2). Meanwhile, from the viewpoint of moldability of the sheet cured product, the content of the cyclic polyolefin resin copolymer (A2) is preferably 90% by mass or less, more preferably 80% by mass or less, and still more preferably 70% by mass or less.

In the second embodiment of the present invention, the "resin components" refer to the cyclic polyolefin resin copolymer (A2) and the thermoplastic resin (B2) contained in the present composition (2), and other resins added as necessary.

The "cyclic" in the cyclic polyolefin resin copolymer (A2) refers to an alicyclic structure of the cyclic polyolefin resin copolymer (A2), and specifically, an alicyclic structure having a side chain of a polyolefin. As a suitable example of the alicyclic structure, cycloalkanes, bicycloalkanes, polycyclic compounds, and the like are exemplary examples. Among these, cycloalkanes are preferable and cyclohexane is more preferable.

In addition, it is more preferable that the alicyclic structure is an alicyclic structure generated by hydrogenation of an aromatic ring included in a hydrogenated aromatic vinyl polymer block unit described later.

A crystal melting peak temperature of the cyclic polyolefin resin copolymer (A2) is lower than 100°C.

The crystal melting peak temperature of the cyclic polyolefin resin copolymer (A2) is preferably 50°C or higher, more preferably 60°C or higher, and still more preferably 65°C or higher. In addition, the crystal melting peak temperature of the cyclic polyolefin resin copolymer (A2) is preferably 90°C or lower and more preferably 85°C or lower.

The crystal melting peak temperature in the present invention is a temperature at which a crystal melting peak is detected in differential scanning calorimetry (DSC) measured at a heating rate of 10 °C/min. It is sufficient that the cyclic polyolefin resin copolymer (A2) of the present composition (2) has a crystal melting peak of lower than 100°C, and for example, it may include a case of two crystal melting peaks of lower than 100°C and 100°C or higher.

As a known cyclic polyolefin, hydrogenated additives of a ring-opening polymer having a repeating unit derived from a monocyclic norbornene-based monomer or a polycyclic norbornene-based monomer (for example, PCT International Publication No. WO2012/046443, PCT International Publication No. WO2012/033076, and the like) are exemplary examples. The cyclic polyolefin has an alicyclic structure in a main chain of the polymer and has a crystal melting peak temperature of lower than 100°C, or is amorphous.

On the other hand, since the cyclic polyolefin resin copolymer (A2) of the present composition (2) has an alicyclic structure in the side chain of polyolefin, the crystal melting peak temperature exists at lower than 100°C.

A dielectric tangent of the cyclic polyolefin resin copolymer (A2) at 10 GHz is preferably less than 0.005 and more preferably less than 0.001. As the dielectric tangent is smaller, dielectric loss is smaller, and thus efficiency and high speed of transmission of electrical signals in a case of being used as a circuit board material are obtained, which is preferable. The lower limit of the dielectric tangent is not particularly limited, and may be 0 or more.

The above-described dielectric tangent is a value obtained by molding the cyclic polyolefin resin copolymer (A2) into a sheet shape having a thickness of 300 µm to obtain a test piece, and measuring a dynamic viscoelasticity with a viscoelastic spectrometer. Measurement conditions may be the same as conditions described in Examples.

A melt flow rate (MFR) of the cyclic polyolefin resin copolymer (A2) is not particularly limited and is usually 0.1 g/10 min or more, and from the viewpoint of molding method and appearance of the molded product, it is preferably 0.5 g/10 min or more. In addition, the above-described melt flow rate (MFR) is usually 200 g/10 min or less, and from the viewpoint of material strength, it is preferably 100 g/10 min or less and more preferably 90.0 g/10 min or less. By setting the MFR to be within the above-described range, compatibility with a thermoplastic resin described later is favorable.

The MFR is determined by performing a measurement under conditions of a measurement temperature of 230°C and a measurement load of 2.16 kg according to ISO R1133.

### <Cyclic polyolefin (a)>

As the cyclic polyolefin resin copolymer (A2) of the present composition (2), from the viewpoint of low dielectric characteristics, a cyclic polyolefin including at least one hydrogenated aromatic vinyl polymer block unit and at least one hydrogenated conjugated diene polymer block unit (hereinafter, also referred to as "cyclic polyolefin (a)") or a modified product of the cyclic polyolefin (a) with at least one of an unsaturated carboxylic acid or an anhydride of the unsaturated carboxylic acid (hereinafter, also referred to as "modified cyclic polyolefin (a')") is preferable.

The "block" in the present invention refers to a polymerization segment of a copolymer which exhibits microphase separation from structurally or compositionally different polymerization segment of the copolymer. The microphase separation occurs in that the polymerization segment is not mixed in the block copolymer.

The microphase separation and the block copolymer are widely studied in pp. 32 to 38 of "Block Copolymers-Designer Soft Materials" in PHYSICS TODAY, February 1999.

As the cyclic polyolefin (a), diblock copolymers consisting of a hydrogenated aromatic vinyl polymer block unit (hereinafter, also referred to as "block A") and a hydrogenated conjugated diene polymer block unit (hereinafter, also referred to as "block B"), and a triblock copolymer, a tetrablock copolymer, and a pentablock copolymer, including two or more of at least one of the block A or the block B, and the like are exemplary examples.

The cyclic polyolefin (a) preferably includes at least two blocks A, and for example, an A-B-A type, an A-B-A-B type, an A-B-A-B-A type, and the like are suitable exemplary examples.

In addition, the cyclic polyolefin (a) preferably includes a segment consisting of an aromatic vinyl polymer at each terminal. Therefore, the hydrogenated block copolymer of the present composition (2) has at least two hydrogenated aromatic vinyl polymer block units (blocks A), and it is preferable that at least one hydrogenated conjugated diene polymer block unit (block B) is present between two hydrogenated aromatic vinyl polymer block units (blocks A). From these viewpoints, the cyclic polyolefin (a) is more preferably an A-B-A type or an A-B-A-B-A type.

A content of the hydrogenated aromatic vinyl polymer block unit (block A) in the cyclic polyolefin (a) is preferably 30 to 99 mol% and more preferably 40 to 90 mol%. Among the above, the content is more preferably 50 mol% or more and still more preferably 60 mol% or more.

In a case where the ratio of the hydrogenated aromatic vinyl polymer block unit (block A) is the above-described lower limit or more, rigidity is not deteriorated, and heat resistance or linear thermal expansion rate are also favorable. On the other hand, in a case where the above-described ratio is the above-described upper limit or less, flexibility is favorable.

In addition, a content of the hydrogenated conjugated diene polymer block unit (block B) in the cyclic polyolefin (a) is preferably 1 to 70 mol% and more preferably 10 to 60 mol%. Among the above, the content is more preferably 50 mol% or less and still more preferably 40 mol% or less.

In a case where the ratio of the hydrogenated conjugated diene polymer block unit (block B) is the above-described lower limit or more, flexibility is favorable. On the other hand, in a case where the above-described ratio is the above-described upper limit or less, rigidity is not deteriorated, and heat resistance or linear thermal expansion rate are also favorable.

Each of the hydrogenated aromatic vinyl polymer block unit and the hydrogenated conjugated diene polymer block unit, constituting the cyclic polyolefin (a), can be obtained by hydrogenating a polymer block composed of an aromatic vinyl monomer or a conjugated diene monomer such as 1,3-butadiene, which will be described later.

In addition, the cyclic polyolefin (a) is preferably a block copolymer having no functional group. The "no functional group" means that no functional group is present in the block copolymer, that is, a group including an atom other than a carbon atom and a hydrogen atom is not present in the block copolymer.

Hereinafter, the monomer for forming the aromatic vinyl polymer block unit and the conjugated diene polymer block unit before hydrogenation will be described.

### (Aromatic vinyl monomer)

An aromatic vinyl monomer which is a raw material for the aromatic vinyl polymer block unit before hydrogenation is a monomer represented by General Formula (1).

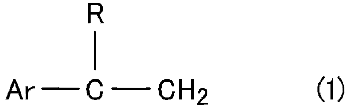

In General Formula (1), R is a hydrogen or an alkyl group, and Ar is a phenyl group, a halophenyl group, an alkylphenyl group, an alkylhalophenyl group, a naphthyl group, a pyridinyl group, or an anthracenyl group.

When the R is an alkyl group, the number of carbon atoms in the alkyl group is preferably 1 to 6, and the alkyl group may be monosubstituted or polysubstituted with a functional group such as a halo group, a nitro group, an amino group, a hydroxy group, a cyano group, a carbonyl group, and a carboxyl group.

In addition, the Ar is preferably a phenyl group or an alkylphenyl group, and more preferably a phenyl group.

As the aromatic vinyl monomer, for example, styrene, α-methylstyrene, vinyltoluene (including all isomers, and p-vinyltoluene is particularly preferable), ethylstyrene, propylstyrene, butylstyrene, vinylbiphenyl, vinylnaphthalene, vinylanthracene (including all isomers), and mixtures thereof are exemplary examples. Among these, styrene is preferable.

### (Conjugated diene monomer)

The conjugated diene monomer which is a raw material for the conjugated diene polymer block unit before hydrogenation is not particularly limited as long as the monomer has two conjugated double bonds.

As the conjugated diene monomer, for example, 1,3-butadiene, 2-methyl-1,3-butadiene (isoprene), 2-methyl-1,3-pentadiene, similar compounds thereof, and mixtures thereof are exemplary examples. Among these, 1,3-butadiene is preferable.

When 1,3-butadiene is used as the conjugated diene monomer, since polybutadiene which is a polymer thereof has a 1,4-bonding unit ([-CH₂-CH=CH-CH₂-]) and a 1,2-bonding unit ([-CH₂-CH(CH=CH₂)-]), due to hydrogenation, the former becomes a structure similar to a repeating unit of polyethylene (ethylene structure) and the latter becomes a structure similar to a repeating unit when 1-butene is polymerized (1-butene structure). Therefore, the hydrogenated conjugated diene polymer block in the present composition (2) preferably includes at least one of an ethylene structure and a 1-butene structure.

In addition, when isoprene is used as the conjugated diene monomer, polyisoprene which is a polymer thereof has a 1,4-bonding unit ([-CH₂-C(CH₃)=CH-CH₂-]), a 3,4-bonding unit ([-CH₂-CH(C(CH₃)=CH₂)-]), and a 1,2-bonding unit ([-CH₂-C(CH₃)(CH=CH₂)-]), the polyisoprene includes at least any one of three kinds of repeating units obtained by hydrogenation.

### (Block structure)

It is preferable that the cyclic polyolefin (a) is produced by hydrogenation of a multiblock copolymer such as a triblock copolymer, a tetrablock copolymer, and a pentablock copolymer, for example, SBS, SBSB, SBSBS, SBSBSB, SIS, SISIS, and SISBS (here, S represents polystyrene, B represents polybutadiene, and I represents polyisoprene). The block may be a linear block or may be branched. When branched, the polymerization chain may be bonded at any position along the skeleton of the copolymer. In addition, the block may be a tapered block or a star block in addition to the linear block.

The block copolymer before hydrogenation, constituting the cyclic polyolefin (a), may include one or a plurality of additional block units other than the aromatic vinyl polymer block unit and the conjugated diene polymer block unit. For example, when a triblock copolymer, these additional block units may be bonded to any position of the triblock polymer skeleton.

As a preferred example of the above-described hydrogenated aromatic vinyl polymer block unit, a hydrogenated polystyrene can be an exemplary example, and as a preferred example of the above-described hydrogenated conjugated diene polymer block unit, a hydrogenated polybutadiene or a hydrogenated polyisoprene can be an exemplary example, in which a hydrogenated polybutadiene is more preferable.

As a preferred aspect of the cyclic polyolefin (a), a hydrogenated triblock copolymer or a hydrogenated pentablock copolymer, including styrene and butadiene, can be an exemplary example, and it is preferable that the cyclic polyolefin (a) does not include any other functional groups or structural modifying agents.

### (Hydrogenation level)

In the cyclic polyolefin (a), in addition to double bonds derived from conjugated diene such as butadiene, an aromatic ring derived from styrene or the like is also hydrogenated, and thus the cyclic polyolefin (a) is substantially completely hydrogenated. Specifically, a hydrogenation level described below is achieved.

A hydrogenation level of the above-described hydrogenated aromatic vinyl polymer block unit is preferably 90% or more, more preferably 95% or more, still more preferably 98% or more, and particularly preferably 99.5% or more.

A hydrogenation level of the above-described hydrogenated conjugated diene polymer block unit is preferably 95% or more, more preferably 99% or more, and still more preferably 99.5% or more.

By carrying out the hydrogenation at a high level in this way, it is possible to reduce dielectric loss, and rigidity and heat resistance are also favorable.

The hydrogenation level of the hydrogenated aromatic vinyl polymer block unit indicates a ratio of aromatic vinyl polymer block units to be saturated by the hydrogenation. The hydrogenation level of the hydrogenated conjugated diene polymer block unit indicates a ratio of conjugated diene polymer block units to be saturated by the hydrogenation.

The hydrogenation level of each block unit is determined using proton NMR.

The cyclic polyolefin (a) may be used alone, or in combination of two or more thereof.

As the cyclic polyolefin (a) in the present composition (2), a commercially available product can be used, and specifically, Tefabloc (registered trademark) manufactured by Mitsubishi Chemical Corporation is an exemplary example.

### <Modified cyclic polyolefin (a')>

As the cyclic polyolefin resin copolymer of the present composition (2), a modified cyclic polyolefin (a') may be used. The modified cyclic polyolefin (a') is a modified product of the above-described cyclic polyolefin (a) with at least one of an unsaturated carboxylic acid or an anhydride thereof.

By modifying the cyclic polyolefin (a), polarity of the polymer is increased, so that improvement of adhesiveness to a metal layer such as a copper foil can be expected.

### (Modification operation of cyclic polyolefin (a))

Hereinafter, a modification operation of the cyclic polyolefin (a) will be described. It is preferable that the modification operation is performed by adding, to the cyclic polyolefin (a), at least one of an unsaturated carboxylic acid or an anhydride thereof as a modifying agent and reacting the mixture.

### [Modifying agent]

As the at least one of an unsaturated carboxylic acid or an anhydride thereof as the above-described modifying agent, for example, unsaturated carboxylic acids such as acrylic acid, methacrylic acid, α-ethyl acrylic acid, maleic acid, fumaric acid, tetrahydrophthalic acid, methyltetrahydrophthalic acid, itaconic acid, citraconic acid, crotonic acid, isocrotonic acid, and nadic acids; and anhydrides thereof are exemplary examples.

In addition, as the acid anhydride, specifically, maleic acid anhydride, citraconic acid anhydride, and nadic acid anhydrides are exemplary examples.

As the nadic acids or anhydrides thereof, endocis-bicyclo[2.2.1]hept-2,3-dicarboxylic acid (nadic acid), methyl-endocis-bicyclo[2.2.1]hept-5-ene-2,3-dicarboxylic acid (methyl nadic acid), and anhydrides thereof are exemplary examples.

Among at least one of these unsaturated carboxylic acids or anhydrides thereof, acrylic acid, maleic acid, nadic acid, maleic acid anhydride, or nadic acid anhydride is preferable.

The at least one of an unsaturated carboxylic acid or an anhydride thereof can be used alone or in combination of two or more thereof.

### [Modifying method]

The modified cyclic polyolefin (a') can be obtained by modifying the above-described cyclic polyolefin (a) with at least one of the above-described unsaturated carboxylic acid or the anhydride thereof. As a method of modification, solution modification, melt modification, solid phase modification by irradiation with electron beams or ionization radiation, modification in a super critical fluid, or the like is suitably used.

Among these, the melt modification in which equipment or cost comparison is excellent is preferable, and melt-kneading modification using an extruder having excellent continuous productivity is more preferable.

As a device used in this method, for example, a single-screw extruder, a twin-screw extruder, a Banbury mixer, and a roll mixer are exemplary examples. Among these, a single-screw extruder or a twin-screw extruder, which have excellent continuous productivity, is preferable.

In general, the modification of the cyclic polyolefin (a) with at least one of an unsaturated carboxylic acid or an anhydride thereof is carried out by a graft reaction in which a carbon-hydrogen bond of the hydrogenated conjugated diene polymer block unit which is one of the block units constituting the cyclic polyolefin (a) is cleaved to generate a carbon radical, and an unsaturated functional group is added thereto.

As a source of the carbon radical, in addition to the electron beams and ionization radiation described above, a method of applying a high temperature and a radical generator such as an organic peroxide, an inorganic peroxide, and an azo compound can be used. As the radical generator, it is preferable to use an organic peroxide from the viewpoint of cost and handleability.

As the above-described azo compound, for example, azobisisobutyronitrile, azobisdimethylvaleronitrile, azobis(2-methylbutyronitrile), and diazonitrophenol are exemplary examples.

As the above-described inorganic peroxide, for example, hydrogen peroxide, potassium peroxide, sodium peroxide, calcium peroxide, magnesium peroxide, and barium peroxide are exemplary examples.

As the above-described organic peroxide, peroxides included in hydroperoxide, dialkyl peroxide, diacyl peroxide, peroxyester, and ketone peroxide groups are exemplary examples.

Specifically, hydroperoxides such as cumene hydroperoxide and tert-butyl hydroperoxide; dialkyl peroxides such as dicumyl peroxide, di-tert-butyl peroxide, 2,5-dimethyl-2,5-di(tert-butylperoxy)hexane, and 2,5-dimethyl-2,5-di(tert-butylperoxy)hexyne-3; diacyl peroxides such as lauryl peroxide and benzoyl peroxide; peroxyesters such as tert-butylperoxyacetate, tert-butylperoxybenzoate, and tert-butylperoxyisopropyl carbonate; and ketone peroxides such as cyclohexanone peroxide are exemplary examples.

These radical generators may be used alone, or in combination of two or more thereof.

### [Melt-kneading modification]

In an operation of the melt-kneading modification generally used, the cyclic polyolefin (a), the at least one of an unsaturated carboxylic acid or an anhydride thereof, and the organic peroxide are blended, put into a kneader or an extruder, and extruded while being heated and melt-kneaded, and a molten resin coming out of a tip dice is cooled in a water tank or the like to obtain the modified cyclic polyolefin (a').

As a blending ratio of the cyclic polyolefin (a) and the at least one of an unsaturated carboxylic acid or an anhydride thereof, an amount of the at least one of an unsaturated carboxylic acid or an anhydride thereof is 0.2 to 5 parts by mass with respect to 100 parts by mass of the cyclic polyolefin (a).

When the blending ratio of the at least one of an unsaturated carboxylic acid or an anhydride thereof to the cyclic polyolefin (a) is the above-described lower limit or more, a predetermined modified rate required to exhibit the effects of the present invention is obtained. In addition, when the above-described blending ratio is the above-described upper limit or less, at least one of the unsaturated carboxylic acid or the anhydride thereof unreacted does not remain, and the dielectric characteristics are also preferable.

As a blending ratio of the above-described at least one of the unsaturated carboxylic acid or the anhydride thereof and the above-described organic peroxide, an amount of the above-described organic peroxide is 20 to 100 parts by mass with respect to 100 parts by mass of the above-described at least one of the unsaturated carboxylic acid or the anhydride thereof.

When the blending ratio of the above-described organic peroxide to the above-described at least one of the unsaturated carboxylic acid or the anhydride thereof is the above-described lower limit or more, a predetermined modified rate required to exhibit the effects of the present invention is obtained. In addition, when the above-described blending ratio is the above-described upper limit or less, deterioration of the cyclic polyolefin (a) does not occur, and color tone is not deteriorated.

In addition, as melt-kneading modification conditions, for example, it is preferable to extrude at a temperature of 150°C to 300°C in a single-screw extruder or a twin-screw extruder.

### [Modified rate]

A modified rate of the modified cyclic polyolefin (a') with the above-described at least one of the unsaturated carboxylic acid or the anhydride thereof is preferably 0.1 % to 2% by mass.

When the above-described modified rate is the above-described lower limit or more, polarity of the polymer is large, and adhesiveness a metal layer such as a copper foil is improved, which is preferable. In addition, where the above-described modified rate is the above-described upper limit or less, it is possible to prevent the deterioration of dielectric loss of the cyclic polyolefin (a). In addition, it is possible to prevent occurrence of an odor or deterioration of a color.

The above-described modified rate of the modified cyclic polyolefin (a') can be measured by proton NMR after subjecting the above-described modified cyclic polyolefin (a') to a methyl esterification treatment.

### 2. Thermoplastic resin (B2)

The thermoplastic resin (B2) of the present composition (2) is at least one selected from the group consisting of a styrene-based thermoplastic elastomer, an olefin-based thermoplastic elastomer, and an ethylene-based polymer.

From the viewpoint of moldability of the sheet cured product, a content of the thermoplastic resin (B2) in the present composition (2) is preferably 10% by mass or more, more preferably 20% by mass or more, and still more preferably 30% by mass or more in the resin components of the present composition (2). On the other hand, from the viewpoint of lowering the linear thermal expansion coefficient of the sheet cured product, the content is preferably 90% by mass or less, more preferably 85% by mass or less, and still more preferably 80% by mass or less.

A mass ratio of the cyclic polyolefin resin copolymer (A2) and the thermoplastic resin (B2) in the present composition (2) is preferably (A2)/(B2) = 10/90 to 90/10, more preferably 15/85 to 80/20, and still more preferably 20/80 to 70/30. When the above-described mass ratio is within the above-described range, the balance between moldability, dielectric characteristics, and linear thermal expansion coefficient of the sheet cured product is favorable.

As the above-described styrene-based thermoplastic elastomer, for example, a styrene-butadiene-styrene block copolymer (SBS), a styrene-isoprene-styrene block copolymer (SIS), a styrene-ethylene-butadiene-styrene block copolymer (SEBS), a styrene-ethylene-propylene-styrene block copolymer (SEPS), a styrene-isobutylene-styrene block copolymer (SIBS), which are obtained by hydrogenating the copolymers, and the like are exemplary examples.

The above-described olefin-based thermoplastic elastomer includes a polyolefin as a hard segment and includes a rubber component as a soft segment.

The above-described olefin-based thermoplastic elastomer may be a mixture (polymer blend) of polyolefin and a rubber component, a crosslinked product obtained by subjecting polyolefin and a rubber component to a crosslinking reaction, or a polymer obtained by polymerizing polyolefin and a rubber component.

As the above-described polyolefin, polypropylene, polyethylene, and the like are exemplary examples.

As the above-described rubber component, diene-based rubbers such as isoprene rubber, butadiene rubber, butyl rubber, propylene-butadiene rubber, acrylonitrile-butadiene rubber, and acrylonitrile-isoprene rubber, ethylene-propylene non-conjugated diene rubber, ethylene-butadiene copolymer rubber, and the like are exemplary examples.

As the above-described ethylene-based polymer, a homopolymer of ethylene, a copolymer of ethylene with other monomers, and the like are exemplary examples.

The above-described copolymer of ethylene with other monomers preferably includes ethylene as a main component. Here, the "including ethylene as a main component" means that an ethylene structural unit in the copolymer is contained in an amount of 50 mol% or more, preferably 60 mol% or more.

In addition, the other monomers copolymerized with the ethylene are not particularly limited as long as the monomers are copolymerizable with the ethylene.

As a preferred example of the above-described ethylene-based polymer, low-density polyethylene (LDPE), linear low-density polyethylene (LLDPE), a polyethylene obtained by a polymerization using a metallocene catalyst, and the like are exemplary examples. Among these, particularly, from the viewpoint of high flexibility, it is preferable to use linear low-density polyethylene (LLDPE).

Among the above, from the viewpoint of low dielectric characteristics and ease of processability, the styrene-based thermoplastic elastomer is preferable, and the styrene-ethylene-butadiene-styrene block copolymer (SEBS) is more preferable.

In addition, among the thermoplastic resins (B2) mentioned above, in particular, when a combination in which the thermoplastic resin (B2) itself is difficult to react with the vinyl-based crosslinking agent (C2) is selected, it is considered that the cyclic polyolefin resin copolymer (A2), the thermoplastic resin (B2), and the vinyl-based crosslinking agent (C2) form an interpenetrating polymer network structure (hereinafter, also referred to as "semi-IPN structure"), which improves the low dielectric characteristics and the heat resistance. The semi-IPN structure is a structure in which, rather than forming a chemical bond between the cyclic polyolefin resin copolymer (A2), the thermoplastic resin (B2), and the vinyl-based crosslinking agent (C2), molecular chains of the cyclic polyolefin resin copolymer (A2), molecular chains of the thermoplastic resin (B2), and molecular chains of the vinyl-based crosslinking agent (C2) are partially and physically entangled with each other. By forming the semi-IPN structure, while maintaining the low dielectric characteristics of the cyclic polyolefin resin copolymer (A2) and the thermoplastic resin (B2), the pseudo-crosslinking density is higher as compared with the cyclic polyolefin resin copolymer (A) or the thermoplastic resin (B2) alone, and it is considered that the elastic modulus is improved and the heat resistance is favorable. From this viewpoint, as the thermoplastic resin (B2), the styrene-based thermoplastic elastomer is preferable; a styrene-isobutylene-styrene block copolymer (SIBS) or a styrene-ethylene-butadiene-styrene block copolymer (SEBS) is more preferable; and a styrene-ethylene-butadiene-styrene block copolymer (SEBS) is still more preferable.

When the styrene-based thermoplastic elastomer is used as the thermoplastic resin (B2), a styrene content is preferably 10% by mass or more and more preferably 15% by mass or more. In addition, the styrene content is preferably 70% by mass or less, more preferably 60% by mass or less, still more preferably 50% by mass or less, and even more preferably 40% by mass or less.

In a case where the styrene content is within the above-described range, the dielectric tangent is low and the elastic modulus is also an appropriate value, so that it is possible to achieve both the low dielectric characteristics and the heat resistance, and handleability is also favorable.

The thermoplastic resin (B2) may be modified by a known method. As the modified product, for example, a reaction product between the thermoplastic resin (B2) mentioned above and at least one of an unsaturated carboxylic acid or an anhydride thereof is an exemplary example.

By modifying the thermoplastic resin (B2), polarity of the polymer is increased, so that improvement of adhesiveness to a metal layer such as a copper foil can be expected.

As the above-described at least one of the unsaturated carboxylic acid or the anhydride thereof, for example, unsaturated carboxylic acids such as acrylic acid, methacrylic acid, α-ethyl acrylic acid, maleic acid, fumaric acid, tetrahydrophthalic acid, methyltetrahydrophthalic acid, itaconic acid, citraconic acid, crotonic acid, isocrotonic acid, and nadic acids; and anhydrides thereof are exemplary examples.

In addition, as the acid anhydride, specifically, maleic acid anhydride, citraconic acid anhydride, and nadic acid anhydrides are exemplary examples.

As the nadic acids or anhydrides thereof, endocis-bicyclo[2.2.1]hept-2,3-dicarboxylic acid (nadic acid), methyl-endocis-bicyclo[2.2.1]hept-5-ene-2,3-dicarboxylic acid (methyl nadic acid), and anhydrides thereof are exemplary examples.

Among at least one of these unsaturated carboxylic acids or anhydrides thereof, acrylic acid, maleic acid, nadic acid, maleic acid anhydride, or nadic acid anhydride is preferable.

The at least one of an unsaturated carboxylic acid or an anhydride thereof can be used alone or in combination of two or more thereof.

A storage elastic modulus of the thermoplastic resin (B2) at 24°C is preferably 0.1 MPa or more and more preferably 1 MPa or more. In addition, the above-described storage elastic modulus is preferably less than 2,000 MPa, more preferably less than 1,500 MPa, still more preferably less than 1,000 MPa, even more preferably less than 500 MPa, even still more preferably less than 300 MPa, still further preferably less than 100 MPa, and even further preferably less than 50 MPa.

By setting the storage elastic modulus to be less than the above-described upper limit value, flexibility of a sheet cured product to be obtained is favorable. In addition, by setting the storage elastic modulus to be the above-described lower limit value or more, heat resistance and handleability of the sheet cured product to be obtained are favorable.

The above-described storage elastic modulus is a value obtained by molding the thermoplastic resin (B2) into a sheet shape having a thickness of 300 µm to obtain a test piece, and measuring a dynamic viscoelasticity with a viscoelastic spectrometer. Measurement conditions may be the same as conditions described in Examples.

A density of the thermoplastic resin (B2) is preferably 0.98 g/cm³ or less, more preferably 0.95 g/cm³ or less, and still more preferably 0.91 g/cm³ or less. On the other hand, the lower limit of the above-described density is not particularly limited, but is preferably 0.80 g/cm³ or more.

By setting the density to be the above-described value or less, flexibility of a sheet cured product to be obtained is favorable.

The above-described density can be measured by molding the thermoplastic resin (B2) into a sheet shape having a thickness of 300 µm to obtain a test piece, and measuring a density in accordance with ASTM D792.

A dielectric tangent of the thermoplastic resin (B2) at 10 GHz is preferably less than 0.003, more preferably less than 0.002, and still more preferably less than 0.001. On the other hand, the lower limit of the above-described dielectric tangent is not particularly limited, and may be 0 or more.

As the dielectric tangent is smaller, dielectric loss is smaller, and thus efficiency and high speed of transmission of electrical signals in a case where the present composition (2) is used as a circuit board material are obtained.

The above-described dielectric tangent is a value obtained by molding the thermoplastic resin (B2) into a sheet shape having a thickness of 300 µm to obtain a test piece, and measuring a dielectric tangent in accordance with JIS C2565:1992 under conditions of a temperature of 23°C and a frequency of 10 GHz.

### 3. Vinyl-based crosslinking agent (C2)

A content of the vinyl-based crosslinking agent (C2) in the present composition (2) is 1 part by mass or more and less than 30 parts by mass with respect to 100 parts by mass of the resin components of the present composition (2), preferably 3 parts by mass or more and 25 parts by mass or less, more preferably 5 parts by mass or more and 20 parts by mass or less, and still more preferably 10 parts by mass or more and 18 parts by mass or less.

In a case where the content of the vinyl-based crosslinking agent (C2) is within the above-described range, the compatibility with the cyclic polyolefin resin copolymer (A2) and the thermoplastic resin (B2) is favorable and the pseudo-crosslinking density is easily increased, so that the heat resistance of the sheet cured product to be obtained is favorable.

The vinyl-based crosslinking agent (C2) of the present composition (2) preferably has a mass-average molecular weight (Mw) of 100 or more and 4,000 or less.

The above-described mass-average molecular weight (Mw) is preferably 120 or more. In addition, the above-described mass-average molecular weight (Mw) is preferably 3,000 or less, more preferably 2,000 or less, still more preferably 1,000 or less, even more preferably 800 or less, and even still more preferably 600 or less.

Since the mass-average molecular weight (Mw) of the vinyl-based crosslinking agent (C2) is within the above-described range, the molecular chains of the cyclic polyolefin resin copolymer (A2), the molecular chains of the thermoplastic resin (B2), and the molecular chains of the vinyl-based crosslinking agent (C2) are easily entangled with each other during curing, and the pseudo-crosslinking density is easily increased, so that the heat resistance of the sheet cured product to be obtained is favorable.

When the crosslinking agent is a partially crosslinked substance or is not a polymer, the "mass-average molecular weight (Mw) of the vinyl-based crosslinking agent (C2)" means a molecular weight of a compound used as the vinyl-based crosslinking agent (C2).

The vinyl-based crosslinking agent (C2) is a crosslinking agent having a vinyl group in the molecule, and also includes a crosslinking agent having an acryl group or a methacrylic group in the molecule. The vinyl-based crosslinking agent (C2) may be any of monofunctional, difunctional, or polyfunctional such as tri- or higher functional.

As the a monofunctional vinyl-based crosslinking agent (C2), for example, monofunctional aliphatic (meth)acrylate compounds such as isooctyl (meth)acrylate, isononyl (meth)acrylate, isodecyl (meth)acrylate, lauryl (meth)acrylate, tridecyl (meth)acrylate, stearyl acrylate, and isostearyl acrylate are exemplary examples.

As a difunctional vinyl-based crosslinking agent (C2), difunctional aromatic vinyl compounds such as divinylbenzene, divinylnaphthalene, and divinylbiphenyl; difunctional aliphatic (meth)acrylate compounds such as ethylene glycol di(meth)acrylate, diethylene glycol di(meth)acrylate, triethylene glycol di(meth)acrylate, tetraethylene glycol di(meth)acrylate, polyethylene glycol di(meth)acrylate, propylene glycol di(meth)acrylate, dipropylene glycol di(meth)acrylate, tripropylene glycol di(meth)acrylate, tetrapropylene glycol di(meth)acrylate, polypropylene glycol di(meth)acrylate, ethoxylated polypropylene glycol di(meth)acrylate, 1,3-butanediol di(meth)acrylate, 1, 4-butanediol di(meth)acrylate, neopentyl glycol di(meth)acrylate, 3-methyl-1,5-pentanediol di(meth)acrylate, 1,6-hexanediol di(meth)acrylate, 2-butyl-2-ethyl-1,3-propanediol di(meth)acrylate, 1,9-nonanediol di(meth)acrylate, 1,10-decanediol di(meth)acrylate, glycerin di(meth)acrylate, tricyclodecane dimethanol di(meth)acrylate, and ethoxylated 2-methyl-1,3-propanediol di(meth)acrylate; difunctional alicyclic (meth)acrylate compounds such as cyclohexane dimethanol di(meth)acrylate, ethoxylated cyclohexane dimethanol di(meth)acrylate, propoxylated cyclohexane dimethanol di(meth)acrylate, ethoxylated and propoxylated cyclohexane dimethanol di(meth)acrylate, tricyclodecane dimethanol di(meth)acrylate, ethoxylated tricyclodecane dimethanol di(meth)acrylate, propoxylated tricyclodecane dimethanol di(meth)acrylate, ethoxylated and propoxylated tricyclodecane dimethanol di(meth)acrylate, ethoxylated and hydrogenated bisphenol A di(meth)acrylate, propoxylated and hydrogenated bisphenol A di(meth)acrylate, ethoxylated, propoxylated, and hydrogenated bisphenol A di(meth)acrylate, ethoxylated and hydrogenated bisphenol F di(meth)acrylate, propoxylated and hydrogenated bisphenol F di(meth)acrylate, and ethoxylated, propoxylated, and hydrogenated bisphenol F di(meth)acrylate; difunctional aromatic (meth)acrylate compounds such as ethoxylated bisphenol A di(meth)acrylate, propoxylated bisphenol A di(meth)acrylate, ethoxylated and propoxylated bisphenol A di(meth)acrylate, ethoxylated bisphenol F di(meth)acrylate, propoxylated bisphenol F di(meth)acrylate, ethoxylated and propoxylated bisphenol F di(meth)acrylate, ethoxylated bisphenol AF di(meth)acrylate, propoxylated bisphenol AF di(meth)acrylate, ethoxylated and propoxylated bisphenol AF di(meth)acrylate, ethoxylated fluorene-type di(meth)acrylate, propoxylated fluorene-type di(meth)acrylate, and ethoxylated and propoxylated fluorene-type di(meth)acrylate; difunctional heterocyclic (meth)acrylate compounds such as ethoxylated isocyanuric acid di(meth)acrylate, propoxylated isocyanuric acid di(meth)acrylate, and ethoxylated and propoxylated isocyanuric acid di(meth)acrylate; and the like are exemplary examples.

As a tri- or higher functional vinyl-based crosslinking agent (C2), trialkenyl isocyanurate compounds such as triallyl cyanurate and triallyl isocyanurate; polyfunctional aliphatic (meth)acrylate compounds such as trimethylolpropane tri(meth)acrylate, ethoxylated trimethylolpropane tri(meth)acrylate, propoxylated trimethylolpropane tri(meth)acrylate, ethoxylated and propoxylated trimethylolpropane tri(meth)acrylate, pentaerythritol tri(meth)acrylate, ethoxylated pentaerythritol tri(meth)acrylate, propoxylated pentaerythritol tri(meth)acrylate, ethoxylated and propoxylated pentaerythritol tri(meth)acrylate, pentaerythritol tetra(meth)acrylate, ethoxylated pentaerythritol tetra(meth)acrylate, propoxylated pentaerythritol tetra(meth)acrylate, ethoxylated and propoxylated pentaerythritol tetra(meth)acrylate, ditrimethylolpropane tetraacrylate, and dipentaerythritol hexa(meth)acrylate; polyfunctional heterocyclic (meth)acrylate compounds such as ethoxylated isocyanuric acid tri(meth)acrylate, propoxylated isocyanuric acid tri(meth)acrylate, and ethoxylated and propoxylated isocyanuric acid tri(meth)acrylate, and the like are exemplary examples.

Among the above, from the viewpoint of compatibility with the cyclic polyolefin resin copolymer (A2) and the thermoplastic resin (B2), at least one selected from the group consisting of a monofunctional aliphatic (meth)acrylate compound, a difunctional aromatic vinyl compound, and a trialkenyl isocyanurate compound is preferable; and from the viewpoint of low dielectric characteristics, a trialkenyl isocyanurate compound is more preferable.

The monofunctional aliphatic (meth)acrylate compound preferably has an alkyl group having 8 or more and 25 or less carbon atoms. The number of carbon atoms is more preferably 10 or more, still more preferably 12 or more, and even more preferably 15 or more. In addition, the number of carbon atoms is more preferably 20 or less. Specifically, at least one selected from the group consisting of isodecyl (meth)acrylate, lauryl (meth)acrylate, tridecyl (meth)acrylate, and isostearyl acrylate is preferable, and isostearyl acrylate is more preferable. In a case where the number of carbon atoms in the alkyl group is within the above-described range, compatibility between the cyclic polyolefin resin copolymer (A2), the thermoplastic resin (B2), and the vinyl-based crosslinking agent (C2) during curing is favorable, the molecular chains thereof are easily entangled with each other, and the pseudo-crosslinking density is easily increased, so that the heat resistance of the sheet cured product to be obtained is favorable.

As the difunctional aromatic vinyl compound, divinylbenzene is preferable.

As the trialkenyl isocyanurate compound, triallyl isocyanurate is preferable.

It is preferable that the vinyl-based crosslinking agent (C2) has no polar functional group in the molecule, or has a small number of polar functional groups in the molecule. When the vinyl-based crosslinking agent (C2) has a cyclic structure, it is preferable that the vinyl-based crosslinking agent (C2) has no polar functional group as a substituent, or a small number of polar functional groups as a substituent.

In a case where the polar functional group is small, the compatibility with the cyclic polyolefin resin copolymer (A2) and the thermoplastic resin (B2) is favorable, and the dielectric tangent of the sheet cured product to be obtained is also low.

The polar functional group means a functional group having a negative atom (for example, nitrogen, oxygen, chlorine, fluorine, and the like) and having a net dipole. For example, an ester group, a carbonyl group, a carboxyl group, a hydroxy group, an amide group, an amino group, and the like are exemplary examples.

When the vinyl-based crosslinking agent (C2) has an ester group, a polar functional group equivalent of the vinyl-based crosslinking agent (C2) (molecular weight of vinyl-based crosslinking agent (C2)/molecular weight of polar functional group (when a plurality of polar functional groups, total amount thereof) is preferably 2 or more, more preferably 3 or more, still more preferably 4 or more, even more preferably 5 or more, and even still more preferably 6 or more.

### 4. Organic peroxide (D2)

The present composition (2) may contain an organic peroxide (D2) for the purpose of promoting a curing reaction.

As the above-described organic peroxide, for example, peroxides included in hydroperoxide, dialkyl peroxide, diacyl peroxide, peroxyester, and ketone peroxide groups are exemplary examples.

Specifically, hydroperoxides such as cumene hydroperoxide and tert-butyl hydroperoxide; dialkyl peroxides such as dicumyl peroxide, di-tert-butyl peroxide, 2,5-dimethyl-2,5-di(tert-butylperoxy)hexane, and 2,5-bis(tert-butylperoxy)-2,5-dimethyl -3-hexyne; diacyl peroxides such as lauryl peroxide and benzoyl peroxide; peroxyesters such as tert-butylperoxyacetate, tert-butylperoxybenzoate, and tert-butylperoxyisopropyl carbonate; and ketone peroxides such as cyclohexanone peroxide are exemplary examples.

A content of the organic peroxide (D2) in the present composition (2) is preferably 0.01 parts by mass or more and 5 parts by mass or less, more preferably 0.05 parts by mass or more and 3 parts by mass or less, and still more preferably 0.1 parts by mass or more and 1 part by mass or less with respect to 100 parts by mass of the resin components of the present composition (2).

In a case where the content of the organic peroxide (D2) is within the above-described range, it is possible to maintain low dielectric characteristics of the sheet cured product while promoting the curing reaction.

### 5. Solvent (E2)

When the resin sheet is manufactured from the present composition (2) through a coating step, the present composition (2) may contain a solvent (E2).

The solvent (E2) is not particularly limited as long as the solvent (E2) is a solvent in which the cyclic polyolefin resin copolymer (A2), the thermoplastic resin (B2), and the vinyl-based crosslinking agent (C2) are uniformly dissolved, and toluene, cyclohexane, tetrahydrofuran, xylene, and the like are exemplary examples.

The solvent (E2) preferably has a boiling point of 200°C or lower so that the solvent (E2) volatilizes in a case where the resin sheet is dried.

From the viewpoint of film forming properties, a content of the solvent (E2) in the present composition (2) is preferably 100 parts by mass or more and 500 parts by mass or less, and more preferably 200 parts by mass or more and 400 parts by mass or less with respect to 100 parts by mass of the resin components of the present composition (2).

### 5. Other components

The present composition (2) may contain, as a component other than the above-described components, a thermoplastic elastomer other than the thermoplastic resin (B2), a crosslinking agent other than the vinyl-based crosslinking agent (C2), an ultraviolet absorber, an antistatic agent, an antioxidant, a coupling agent, a plasticizer, a flame retardant, a colorant, a dispersant, an emulsifier, a low elastic agent, a diluent, an antifoaming agent, an ion trap agent, a thickener, a leveling agent, inorganic particles, organic particles, or the like.

As the crosslinking agent other than the vinyl-based crosslinking agent (C2), for example, a bismaleimide compound, an epoxy compound, and the like are exemplary examples.

As the inorganic particles, for example, calcium carbonate, magnesium carbonate, barium carbonate, magnesium sulfate, barium sulfate, calcium sulfate, zinc oxide, magnesium oxide, calcium oxide, titanium oxide, aluminum oxide, alumina, aluminum hydroxide, hydroxyapatite, silica, magnesium silicate, mica, talc, kaolin, clay, glass powder, asbestos powder, zeolite, white silica, and the like are exemplary examples.

As the organic particles, for example, (meth)acrylate-based resin particles, styrene-based resin particles, silicone-based resin particles, nylon-based resin particles, polyethylene-based resin particles, benzoguanamine-based resin particles, urethane-based resin particles, and the like are exemplary examples.

When containing inorganic particles or organic particles, a content thereof is preferably 1 part by mass or more and 250 parts by mass or less, more preferably 10 parts by mass or more and 200 parts by mass or less, and still more preferably 20 parts by mass or more and 150 parts by mass or less with respect to 100 parts by mass of the resin components of the present composition (2). In a case where the content of the inorganic particles or the organic particles is the above-described lower limit value or more, the dielectric characteristics of the sheet cured product can be further lowered, and the linear thermal expansion coefficient of the sheet cured product can be further reduced. On the other hand, in a case where the content of the inorganic particles or the organic particles is the above-described upper limit value or less, moldability of the sheet cured product is favorable.

### 6. Suitable aspects

As a combination of the cyclic polyolefin resin copolymer (A2), the thermoplastic resin (B2), and the vinyl-based crosslinking agent (C2) in the present composition (2),
a combination of the resin copolymer including at least one hydrogenated aromatic vinyl polymer block unit and at least one hydrogenated conjugated diene polymer block unit or the modified product of the resin copolymer with at least one of an unsaturated carboxylic acid or an anhydride thereof, the styrene-based thermoplastic elastomer, and at least one selected from the group consisting of a monofunctional aliphatic (meth)acrylate compound, a difunctional aromatic vinyl compound, and a trialkenyl isocyanurate compound is preferable; a combination of the modified product of the resin copolymer including at least one hydrogenated aromatic vinyl polymer block unit and at least one hydrogenated conjugated diene polymer block unit with at least one of an unsaturated carboxylic acid or an anhydride thereof, the styrene-based thermoplastic elastomer, and at least one selected from the group consisting of a monofunctional aliphatic (meth)acrylate compound, a difunctional aromatic vinyl compound, and a trialkenyl isocyanurate compound is more preferable; a combination of the modified product of the resin copolymer including at least one hydrogenated aromatic vinyl polymer block unit and at least one hydrogenated conjugated diene polymer block unit with at least one of an unsaturated carboxylic acid or an anhydride thereof, a styrene-isobutylene-styrene block copolymer (SIBS) or a styrene-ethylene-butadiene-styrene block copolymer (SEBS), and at least one selected from the group consisting of a monofunctional aliphatic (meth)acrylate compound, a difunctional aromatic vinyl compound, and a trialkenyl isocyanurate compound is still more preferable; and a combination of the modified product of the resin copolymer including at least one hydrogenated aromatic vinyl polymer block unit and at least one hydrogenated conjugated diene polymer block unit with at least one of an unsaturated carboxylic acid or an anhydride thereof, a styrene-ethylene-butadiene-styrene block copolymer (SEBS), and at least one selected from the group consisting of a monofunctional aliphatic (meth)acrylate compound, a difunctional aromatic vinyl compound, and a trialkenyl isocyanurate compound is even more preferable. In addition, a combination of the modified product of the resin copolymer including at least one hydrogenated aromatic vinyl polymer block unit and at least one hydrogenated conjugated diene polymer block unit with at least one of an unsaturated carboxylic acid or an anhydride thereof, the styrene-based thermoplastic elastomer, and the trialkenyl isocyanurate compound is also preferable; a combination of the modified product of the resin copolymer including at least one hydrogenated aromatic vinyl polymer block unit and at least one hydrogenated conjugated diene polymer block unit with at least one of an unsaturated carboxylic acid or an anhydride thereof, a styrene-isobutylene-styrene block copolymer (SIBS) or a styrene-ethylene-butadiene-styrene block copolymer (SEBS), and the trialkenyl isocyanurate compound is also preferable; and a combination of the modified product of the resin copolymer including at least one hydrogenated aromatic vinyl polymer block unit and at least one hydrogenated conjugated diene polymer block unit with at least one of an unsaturated carboxylic acid or an anhydride thereof, a styrene-ethylene-butadiene-styrene block copolymer (SEBS), and the trialkenyl isocyanurate compound is still more preferable.

### <Resin sheet>

The resin sheet according to one embodiment of the present invention (hereinafter, also referred to as "present resin sheet (2)") is obtained by molding the present composition (2) into a sheet shape in an uncured state.

A thickness of the present resin sheet (2) after curing is preferably 5 to 400 µm, more preferably 10 to 350 µm, and still more preferably 15 to 300 µm.

By setting the thickness of the present resin sheet (2) after curing to be the above-described lower limit value or more, handleability is favorable. In addition, by setting the above-described thickness to be the above-described upper limit value or less, followability to steps of a substrate is favorable when the present resin sheet (2) is used as a circuit board material.

The above-described thickness is a value obtained by heat-pressing the present resin sheet (2) under conditions of 200°C and 0.2 MPa for 30 minutes to obtain a cured product, and measuring a thickness of the obtained cured product with a micrometer.

A specific dielectric constant of the present resin sheet (2) after curing is preferably 4 or less, more preferably 3.5 or less, and still more preferably 3.0 or less. On the other hand, the lower limit of the above-described specific dielectric constant is not particularly limited, and may be 1 or more.

In addition, a dielectric tangent of the present resin sheet (2) after curing is preferably 0.003 or less, more preferably 0.002 or less, and still more preferably 0.0015 or less. On the other hand, the lower limit of the above-described dielectric tangent is not particularly limited, and may be 0 or more.

The above-described specific dielectric constant and dielectric tangent are values obtained by heat-pressing the present resin sheet (2) under conditions of 200°C and 0.2 MPa for 30 minutes to obtain a cured product as a test piece, and measuring a specific dielectric constant and a dielectric tangent thereof in accordance with JIS C2565:1992 under conditions of a temperature of 23°C and a frequency of 10 GHz.

A linear thermal expansion coefficient of the present resin sheet (2) after curing is preferably 150 ppm/°C or less, more preferably 120 ppm/°C or less, still more preferably 110 ppm/°C or less, and even more preferably 105 ppm/°C or less. The lower limit of the linear thermal expansion coefficient is not particularly limited, but is preferably 10 ppm/°C or more from the viewpoint of preventing peeling or deformation with the conductor from occurring when the sheet cured product is used as a circuit board material.

The above-described linear thermal expansion coefficient can be measured by heat-pressing the present resin sheet (2) under conditions of 200°C and 0.2 MPa for 30 minutes to obtain a cured product as a test piece, and performing thermomechanical analysis by a method in accordance with JIS K7197 (2012). Specifically, using a thermal analyzer "TMA 841" (manufactured by METTLER TOLEDO), a sample shape is set to a width of 5 mm and a length of 16 mm, and measurement is started from 30°C up to 100°C at 5 °C/min. Thereafter, the sample is cooled to 0°C and re-heated up to 150°C, and a change in dimension in the re-heating process is measured. Based on this result, an average value of thermal expansion rates in an in-plane direction at 0°C to 120°C is calculated to obtain the linear thermal expansion coefficient.

### <Multilayer body>

In order to improve handleability, in the same manner as the present resin sheet (1), the present resin sheet (2) is preferably formed into a multilayer body by providing a release film on one or both surfaces thereof.

As the release film, the same film as described in the first embodiment can be used, and preferred conditions thereof are also the same.

The multilayer body including the present resin sheet (2) may be wound around a core to form a wound body in the same manner as the multilayer body including the present resin sheet (1), and preferred conditions thereof are also the same.

### <Manufacturing method of resin sheet>

Hereinafter, a manufacturing method of the present resin sheet (2) will be described, but the manufacturing method of the present resin sheet (2) is not limited to the following manufacturing method.

### [First manufacturing method]

A first manufacturing method of the present resin sheet (2) includes a coating liquid preparing step of preparing a coating liquid containing the resin composition, and a molding step of molding the coating liquid into a sheet shape.

In the coating liquid preparing step, a coating liquid is obtained by stirring and uniformly mixing the cyclic polyolefin resin copolymer (A2), the thermoplastic resin (B2), the vinyl-based crosslinking agent (C2), and the organic peroxide (D2), the solvent (E2), and other components, which are added as necessary.

Except for the above-described configuration, the process can be performed in the same manner as the first manufacturing method described in the first embodiment, and preferred conditions thereof are also the same.

### [Second manufacturing method]

A second manufacturing method of the present resin sheet (2) includes a film forming step of extruding the resin composition onto the release film.

In the film forming step, the cyclic polyolefin resin copolymer (A2), the thermoplastic resin (B2), the vinyl-based crosslinking agent (C2), and the organic peroxide (D2) and other components, which are added as necessary, are kneaded using a single-screw extruder or a twin-screw extruder, and film formation is performed by extruding the resin composition onto the release film using an extruder under a temperature condition which is a melting point of the thermoplastic resin (B2) or higher and lower than a crosslinking temperature of the vinyl-based crosslinking agent (C2). The extrusion method of the resin composition is not particularly limited, and more specifically, T-die molding is an exemplary example.

### <Sheet cured product>

The sheet cured product according to one embodiment of the present invention (hereinafter, also referred to as "present cured product (2)") is obtained by curing the present resin sheet (2).

A curing temperature of the present resin sheet (2) may be a temperature at which the cyclic polyolefin resin copolymer (A2) and the thermoplastic resin (B2) do not flow and the crosslinking reaction of the vinyl-based crosslinking agent (C2) proceeds. Specifically, the curing temperature of the present resin sheet (2) is preferably 120°C to 300°C, more preferably 140°C to 250°C, and still more preferably 150°C to 220°C.

In addition, a curing time of the present resin sheet (2) is not particularly limited, but is preferably 10 minutes to 1 hour.

### <Applications of resin composition, resin sheet, and sheet cured product>

As applications of the present composition (2), the present resin sheet (2), and the present cured product (2) according to the embodiments of the present invention, for example, copper foil laminated plates, stretchable substrates, flexible printed circuit boards, multilayer printed wiring boards, circuit board materials for electrical and electronic equipment, such as a capacitor, underfill materials, interchip fill for 3D-LSI, insulating sheets, damping materials, adhesives agents, solder resists, semiconductor encapsulants, hole filling resins, component embedding resin, and the like are exemplary examples, but the present invention is not limited thereto.

### <Circuit board material>

In the same manner as the present resin sheet (1), the present resin sheet (2) according to one embodiment of the present invention can be formed into a circuit board material by being laminated with a conductor.

When used as a circuit board material for electrical and electronic equipment, a thickness of the present resin sheet (2) is preferably 10 µm or more and 500 µm or less. In addition, a thickness of the conductor is preferably 0.2 µm or more and 70 µm or less.

### <Manufacturing method of circuit board material>

The circuit board material including the present resin sheet (2) can be manufactured by, for example, the same method as the manufacturing method of the circuit board material including the present resin sheet (1).

The present resin sheet (2) according to one embodiment of the present invention is laminated on a conductor, and the resin sheet is thermally cured to form an insulating layer. A conductor is further laminated on the insulating layer, and a necessary number of such layers is laminated.

A curing temperature of the present resin sheet (2) may be a temperature at which the cyclic polyolefin resin copolymer (A2) and the thermoplastic resin (B2) do not flow and the crosslinking reaction of the vinyl-based crosslinking agent (C2) proceeds. Specifically, the curing temperature of the resin sheet is preferably 120°C to 300°C, more preferably 140°C to 250°C, and still more preferably 150°C to 220°C.

In addition, a curing time is not particularly limited, but is preferably 10 minutes to 1 hour.

### [Third embodiment]

### <Resin composition>

The resin composition according to one embodiment of the present invention (hereinafter, also referred to as "present composition (3)") contains at least one thermoplastic resin (A3) selected from the group consisting of a styrene-based thermoplastic elastomer, an olefin-based thermoplastic elastomer, and an ethylene-based polymer, a monofunctional (meth)acrylate (B3) having a long chain alkyl group, and a polyfunctional (meth)acrylate (C3).

The reason why heat resistance of a sheet cured product and a circuit board material, including the present composition (3), is favorable is not clear, but it is considered that this is because, in a case where the present composition (3) is cured, the monofunctional (meth)acrylate (B3) having a long chain alkyl group and the polyfunctional (meth)acrylate (C3), which are entangled with the thermoplastic resin (A3), increases a pseudo-crosslinking density, which improves elastic modulus.

Hereinafter, each component of the present composition (3) will be described.

### 1. Thermoplastic resin (A3)

The thermoplastic resin (A3) of the present composition (3) is at least one selected from the group consisting of a styrene-based thermoplastic elastomer, an olefin-based thermoplastic elastomer, and an ethylene-based polymer.

As the above-described styrene-based thermoplastic elastomer, for example, a styrene-butadiene-styrene block copolymer (SBS), a styrene-isoprene-styrene block copolymer (SIS), a styrene-ethylene-butadiene-styrene block copolymer (SEBS), a styrene-ethylene-propylene-styrene block copolymer (SEPS), a styrene-isobutylene-styrene block copolymer (SIBS), which are obtained by hydrogenating the copolymers, and the like are exemplary examples.

The above-described olefin-based thermoplastic elastomer includes a polyolefin as a hard segment and includes a rubber component as a soft segment.

The above-described olefin-based thermoplastic elastomer may be a mixture (polymer blend) of polyolefin and a rubber component, a crosslinked product obtained by subjecting polyolefin and a rubber component to a crosslinking reaction, or a polymer obtained by polymerizing polyolefin and a rubber component.

As the above-described polyolefin, polypropylene, polyethylene, and the like are exemplary examples.

As the above-described rubber component, diene-based rubbers such as isoprene rubber, butadiene rubber, butyl rubber, propylene-butadiene rubber, acrylonitrile-butadiene rubber, and acrylonitrile-isoprene rubber, ethylene-propylene non-conjugated diene rubber, ethylene-butadiene copolymer rubber, and the like are exemplary examples.

As the above-described ethylene-based polymer, a homopolymer of ethylene, a copolymer of ethylene with other monomers, and the like are exemplary examples.

The above-described copolymer of ethylene with other monomers preferably includes ethylene as a main component. Here, the "including ethylene as a main component" means that an ethylene structural unit in the copolymer is contained in an amount of 50 mol% or more, preferably 60 mol% or more.

In addition, the other monomers copolymerized with the ethylene are not particularly limited as long as the monomers are copolymerizable with the ethylene.

As a preferred example of the above-described ethylene-based polymer, low-density polyethylene (LDPE), linear low-density polyethylene (LLDPE), a polyethylene obtained by a polymerization using a metallocene catalyst, and the like are exemplary examples. Among these, from the viewpoint of high flexibility, it is particularly preferable to use linear low-density polyethylene (LLDPE).

Among the above-mentioned thermoplastic resins (A3), from the viewpoint of low dielectric characteristics and ease of processability, the styrene-based thermoplastic elastomer is preferable, and the styrene-ethylene-butadiene-styrene block copolymer (SEBS) is more preferable.

In addition, among the thermoplastic resins (A3) mentioned above, in particular, when a combination in which the thermoplastic resin (A3) itself is difficult to react with each of the monofunctional (meth)acrylate (B3) having a long chain alkyl group and the polyfunctional (meth)acrylate (C3) is selected, it is considered that the thermoplastic resin (A3), the monofunctional (meth)acrylate (B3) having a long chain alkyl group, and the polyfunctional (meth)acrylate (C3) form an interpenetrating polymer network structure (hereinafter, also referred to as "semi-IPN structure"), which improves the low dielectric characteristics and the heat resistance. The semi-IPN structure is a structure in which, rather than forming a chemical bond between the thermoplastic resin (A3), the monofunctional (meth)acrylate (B3) having a long chain alkyl group, and the polyfunctional (meth)acrylate (C3), molecular chains of the thermoplastic resin (A3), molecular chains of the monofunctional (meth)acrylate (B3) having a long chain alkyl group, and molecular chains of the polyfunctional (meth)acrylate (C3) are partially and physically entangled with each other. By forming the semi-IPN structure, while maintaining the low dielectric characteristics of the thermoplastic resin (A3), the pseudo-crosslinking density is higher as compared with the thermoplastic resin (A3) alone. Therefore, it is considered that the elastic modulus is improved and the heat resistance is favorable. From this viewpoint, among the above-mentioned thermoplastic resins (A3), the styrene-based thermoplastic elastomer is preferable; a styrene-isobutylene-styrene block copolymer (SIBS) or a styrene-ethylene-butadiene-styrene block copolymer (SEBS) is more preferable; and a styrene-ethylene-butadiene-styrene block copolymer (SEBS) is still more preferable.

When the styrene-based thermoplastic elastomer is used as the thermoplastic resin (A3), a styrene content is preferably 10% by mass or more and more preferably 15% by mass or more. In addition, the styrene content is preferably 70% by mass or less, more preferably 60% by mass or less, still more preferably 50% by mass or less, and even more preferably 40% by mass or less.

In a case where the styrene content is within the above-described range, the dielectric tangent of the thermoplastic resin (A3) is low and the elastic modulus is also an appropriate value, so that it is possible to achieve both the low dielectric characteristics and the heat resistance, and handleability is also favorable.

The thermoplastic resin (A3) may be modified by a known method. As the modified product, for example, a reaction product between the thermoplastic resin (A3) mentioned above and at least one of an unsaturated carboxylic acid or an anhydride thereof is an exemplary example.

By modifying the thermoplastic resin (A3), polarity of the polymer is increased, so that improvement of adhesiveness to a metal layer such as a copper foil can be expected.

As the above-described at least one of the unsaturated carboxylic acid or the anhydride thereof, for example, unsaturated carboxylic acids such as acrylic acid, methacrylic acid, α-ethyl acrylic acid, maleic acid, fumaric acid, tetrahydrophthalic acid, methyltetrahydrophthalic acid, itaconic acid, citraconic acid, crotonic acid, isocrotonic acid, and nadic acids; and anhydrides thereof are exemplary examples.

In addition, as the acid anhydride, specifically, maleic acid anhydride, citraconic acid anhydride, and nadic acid anhydrides are exemplary examples.

As the nadic acids or anhydrides thereof, endocis-bicyclo[2.2.1]hept-2,3-dicarboxylic acid (nadic acid), methyl-endocis-bicyclo[2.2.1]hept-5-ene-2,3-dicarboxylic acid (methyl nadic acid), and anhydrides thereof are exemplary examples.

Among at least one of these unsaturated carboxylic acids or anhydrides thereof, acrylic acid, maleic acid, nadic acid, maleic acid anhydride, or nadic acid anhydride is preferable.

The at least one of an unsaturated carboxylic acid or an anhydride thereof can be used alone or in combination of two or more thereof.

From the viewpoint of low dielectric characteristics, a content of the thermoplastic resin (A3) in the present composition (3) in resin components of the present composition (3) is preferably 60% by mass or more, more preferably 70% by mass or more, still more preferably 80% by mass or more, and even more preferably 85% by mass or more. The upper limit of the above-described content is not particularly limited, and the resin components of the present composition (3) may be only the thermoplastic resin (A3) (100% by mass).

In the present invention, the "resin components" refer to the thermoplastic resin (A3) contained in the present composition (3) and other resins added as necessary.

A storage elastic modulus of the thermoplastic resin (A3) at 24°C is preferably 0.1 MPa or more and more preferably 1 MPa or more. In addition, the above-described storage elastic modulus is preferably less than 2,000 MPa, more preferably less than 1,500 MPa, still more preferably less than 1,000 MPa, even more preferably less than 500 MPa, even still more preferably less than 300 MPa, still further preferably less than 100 MPa, and even further preferably less than 50 MPa.

By setting the storage elastic modulus to be less than the above-described upper limit value, flexibility of a sheet cured product to be obtained is favorable.

In addition, by setting the storage elastic modulus to be the above-described lower limit value or more, heat resistance and handleability of the sheet cured product to be obtained are favorable.

The above-described storage elastic modulus is a value obtained by molding the thermoplastic resin (A3) into a sheet shape having a thickness of 300 µm to obtain a test piece, and measuring a dynamic viscoelasticity with a viscoelastic spectrometer. Measurement conditions may be the same as conditions described in Examples.

A density of the thermoplastic resin (A3) is preferably 0.98 g/cm³ or less, more preferably 0.95 g/cm³ or less, and still more preferably 0.91 g/cm³ or less. On the other hand, the lower limit of the above-described density is not particularly limited, but is preferably 0.80 g/cm³ or more.

By setting the density to be the above-described value or less, flexibility of a sheet cured product to be obtained is favorable.

The above-described density can be measured by molding the thermoplastic resin (A3) into a sheet shape having a thickness of 300 µm to obtain a test piece, and measuring a density in accordance with ASTM D792.

A dielectric tangent of the thermoplastic resin (A3) at 10 GHz is preferably less than 0.003, more preferably less than 0.002, and still more preferably less than 0.001.

On the other hand, the lower limit thereof is not particularly limited, and may be 0 or more.

As the dielectric tangent is smaller, dielectric loss is smaller, and thus efficiency and high speed of transmission of electrical signals in a case where the present composition (3) is used as a circuit board material are obtained.

The above-described dielectric tangent is a value obtained by molding the thermoplastic resin (A3) into a sheet shape having a thickness of 300 µm to obtain a test piece, and measuring a dielectric tangent in accordance with JIS C2565:1992 under conditions of a temperature of 23°C and a frequency of 10 GHz.

### 2. Monofunctional (meth)acrylate (B3) having long chain alkyl group and polyfunctional (meth)acrylate (C3)

It is preferable that the present composition (3) contains the monofunctional (meth)acrylate (B3) having a long chain alkyl group and the polyfunctional (meth)acrylate (C3) in a total amount of 1 part by mass or more and less than 30 parts by mass with respect to 100 parts by mass of the above-described thermoplastic resin (A3).

The total of the content of the monofunctional (meth)acrylate (B3) having a long chain alkyl group and the content of the polyfunctional (meth)acrylate (C3) is preferably 3 parts by mass or more and 25 parts by mass or less, more preferably 5 parts by mass or more and 20 parts by mass or less, and still more preferably 10 parts by mass or more and 18 parts by mass or less with respect to 100 parts by mass of the thermoplastic resin (A3).

When the total of the content of the monofunctional (meth)acrylate (B3) having a long chain alkyl group and the content of the polyfunctional (meth)acrylate (C3) is within the above-described range, compatibility with thermoplastic resin (A3) is favorable and the pseudo-crosslinking density is easily increased, so that the heat resistance of the sheet cured product to be obtained is favorable.

A mass ratio (B3):(C3) of the monofunctional (meth)acrylate (B3) having a long chain alkyl group and the polyfunctional (meth)acrylate (C3) is preferably 50:50 to 99:1, more preferably 50:50 to 90: 10, still more preferably 50:50 to 80:20, and even more preferably 50:50 to 70:30.

When the mass ratio of the monofunctional (meth)acrylate (B3) having a long chain alkyl group and the polyfunctional (meth)acrylate (C3) is within the above-described range, the compatibility with thermoplastic resin (A3) is favorable and the pseudo-crosslinking density is easily increased, so that the heat resistance of the sheet cured product to be obtained is favorable.

### (1) Monofunctional (meth)acrylate (B3) having long chain alkyl group

As the monofunctional (meth)acrylate (B3) having a long chain alkyl group, for example, a compound represented by CH₂=C(R¹)COOR² (R¹ represents a hydrogen or a methyl group, and R² represents a linear, branched, or cyclic alkyl group having 8 or more and 25 or less carbon atoms), that is, a compound having one group selected from the group consisting of an acryloyloxy group (CH₂=CH-COO-) and a methacryloyloxy group (CH₂=C(CH₃)-COO-) is an exemplary example, and the compound in which the linear, branched, or cyclic alkyl group having 8 or more and 25 or less carbon atoms is included is preferable. The number of carbon atoms is more preferably 10 or more, still more preferably 12 or more, and even more preferably 15 or more. In addition, the number of carbon atoms is more preferably 20 or less.

Furthermore, as the above-described monofunctional (meth)acrylate (B3) having a long chain alkyl group, a monofunctional (meth)acrylate having a branched long chain alkyl group having 8 or more and 25 or less carbon atoms is preferable, a monofunctional (meth)acrylate having a branched long chain alkyl group having 10 or more and 25 or less carbon atoms is more preferable, and a monofunctional (meth)acrylate having a branched long chain alkyl group having 12 or more and 20 or less carbon atoms is most preferable.

When the number of carbon atoms in the alkyl group is within the above-described range, compatibility with the thermoplastic resin (A3), the polyfunctional (meth)acrylate (C3), and the monofunctional (meth)acrylate (B3) having a long chain alkyl group is favorable, the molecular chains thereof are easily entangled with each other during curing, so that the pseudo-crosslinking density is easily increased and the heat resistance of the sheet cured product to be obtained is favorable.

As the monofunctional (meth)acrylate (B3) having a long chain alkyl group, specifically, isooctyl (meth)acrylate, isononyl (meth)acrylate, isodecyl (meth)acrylate, lauryl (meth)acrylate, tridecyl (meth)acrylate, stearyl (meth)acrylate, isostearyl (meth)acrylate, and the like are exemplary examples; and among these, at least one selected from the group consisting of isodecyl (meth)acrylate, lauryl (meth)acrylate, tridecyl (meth)acrylate, and isostearyl (meth)acrylate is preferable, at least one selected from the group consisting of isodecyl (meth)acrylate and isostearyl (meth)acrylate is more preferable, and isostearyl (meth)acrylate is most preferable.

A mass-average molecular weight (Mw) of the monofunctional (meth)acrylate (B3) having a long chain alkyl group is preferably 100 or more and 4,000 or less, more preferably 120 or more and 3,000 or less, still more preferably 2,000 or less, even more preferably 1,000 or less, even still more preferably 800 or less, and still further preferably 600 or less.

When the mass-average molecular weight (Mw) of the monofunctional (meth)acrylate (B3) having a long chain alkyl group is within the above-described range, the molecular chains of the thermoplastic resin (A3), the monofunctional (meth)acrylate (B3) having a long chain alkyl group, and the polyfunctional (meth)acrylate (C3) are entangled with each other during curing, and the pseudo-crosslinking density is easily increased. Therefore, the heat resistance of the sheet cured product to be obtained is favorable.

The monofunctional (meth)acrylate (B3) having a long chain alkyl group has an ester group in the molecule, but it is preferable that such a polar functional group is small.

In addition, similarly when having a long chain alkyl group in which at least one hydrogen atom is substituted by a polar functional group, it is preferable that the polar functional group is small.

In a case where the polar functional group is small, the compatibility with the thermoplastic resin (A3) and the polyfunctional (meth)acrylate (C3) is favorable, and the dielectric tangent of the sheet cured product to be obtained is also low.

The polar functional group means a functional group having a negative atom (for example, nitrogen, oxygen, chlorine, fluorine, and the like) and having a net dipole. For example, an ester group, a carbonyl group, a carboxyl group, a hydroxy group, an amide group, an amino group, and the like are exemplary examples.

A polar functional group equivalent of the monofunctional (meth)acrylate (B3) having a long chain alkyl group (molecular weight of the monofunctional (meth)acrylate (B3) having a long chain alkyl group/molecular weight of a polar functional group (when a plurality of polar functional groups, total amount thereof)) is preferably 2 or more, more preferably 4 or more, and still more preferably 6 or more.

### (2) Polyfunctional (meth)acrylate (C3)

The polyfunctional (meth)acrylate (C3) refers to a di- or higher functional (meth)acrylate, and for example, a polyfunctional aliphatic (meth)acrylate compound, a polyfunctional alicyclic (meth)acrylate compound, a polyfunctional aromatic (meth)acrylate compound, a polyfunctional heterocyclic (meth)acrylate compound, and the like are exemplary examples.

As the polyfunctional aliphatic (meth)acrylate compound, for example, ethylene glycol di(meth)acrylate, diethylene glycol di(meth)acrylate, triethylene glycol di(meth)acrylate, tetraethylene glycol di(meth)acrylate, polyethylene glycol di(meth)acrylate, propylene glycol di(meth)acrylate, dipropylene glycol di(meth)acrylate, tripropylene glycol di(meth)acrylate, tetrapropylene glycol di(meth)acrylate, polypropylene glycol di(meth)acrylate, ethoxylated polypropylene glycol di(meth)acrylate, 1,3-butanediol di(meth)acrylate, 1,4-butanediol di(meth)acrylate, neopentyl glycol di(meth)acrylate, 3-methyl-1,5-pentanediol di(meth)acrylate, 1,6-hexanediol di(meth)acrylate, 2-butyl-2-ethyl-1,3-propanediol di(meth)acrylate, 1,9-nonanediol di(meth)acrylate, 1,10-decanediol di(meth)acrylate, glycerin di(meth)acrylate, tricyclodecane dimethanol di(meth)acrylate, ethoxylated 2-methyl-1,3-propanediol di(meth)acrylate, trimethylolpropane tri(meth)acrylate, ethoxylated trimethylolpropane tri(meth)acrylate, propoxylated trimethylolpropane tri(meth)acrylate, ethoxylated and propoxylated trimethylolpropane tri(meth)acrylate, pentaerythritol tri(meth)acrylate, ethoxylated pentaerythritol tri(meth)acrylate, propoxylated pentaerythritol tri(meth)acrylate, ethoxylated and propoxylated pentaerythritol tri(meth)acrylate, pentaerythritol tetra(meth)acrylate, ethoxylated pentaerythritol tetra(meth)acrylate, propoxylated pentaerythritol tetra(meth)acrylate, ethoxylated and propoxylated pentaerythritol tetra(meth)acrylate, ditrimethylolpropane tetraacrylate, and dipentaerythritol hexa(meth)acrylate, and the like are exemplary examples.

As the polyfunctional alicyclic (meth)acrylate compound, for example, cyclohexane dimethanol di(meth)acrylate, ethoxylated cyclohexane dimethanol di(meth)acrylate, propoxylated cyclohexane dimethanol di(meth)acrylate, ethoxylated and propoxylated cyclohexane dimethanol di(meth)acrylate, tricyclodecane dimethanol di(meth)acrylate, ethoxylated tricyclodecane dimethanol di(meth)acrylate, propoxylated tricyclodecane dimethanol di(meth)acrylate, ethoxylated and propoxylated tricyclodecane dimethanol di(meth)acrylate, ethoxylated and hydrogenated bisphenol A di(meth)acrylate, propoxylated and hydrogenated bisphenol A di(meth)acrylate, ethoxylated, propoxylated, and hydrogenated bisphenol A di(meth)acrylate, ethoxylated and hydrogenated bisphenol F di(meth)acrylate, propoxylated and hydrogenated bisphenol F di(meth)acrylate, ethoxylated, propoxylated, and hydrogenated bisphenol F di(meth)acrylate, and the like are exemplary examples.

As the polyfunctional aromatic (meth)acrylate compound, for example, ethoxylated bisphenol A di(meth)acrylate, propoxylated bisphenol A di(meth)acrylate, ethoxylated and propoxylated bisphenol A di(meth)acrylate, ethoxylated bisphenol F di(meth)acrylate, propoxylated bisphenol F di(meth)acrylate, ethoxylated and propoxylated bisphenol F di(meth)acrylate, ethoxylated bisphenol AF di(meth)acrylate, propoxylated bisphenol AF di(meth)acrylate, ethoxylated and propoxylated bisphenol AF di(meth)acrylate, ethoxylated fluorene-type di(meth)acrylate, propoxylated fluorene-type di(meth)acrylate, ethoxylated and propoxylated fluorene-type di(meth)acrylate, and the like are exemplary examples.

As the polyfunctional heterocyclic (meth)acrylate compound, for example, ethoxylated isocyanuric acid di(meth)acrylate, propoxylated isocyanuric acid di(meth)acrylate, ethoxylated and propoxylated isocyanuric acid di(meth)acrylate, ethoxylated isocyanuric acid tri(meth)acrylate, propoxylated isocyanuric acid tri(meth)acrylate, and ethoxylated and propoxylated isocyanuric acid tri(meth)acrylate, and the like are exemplary examples.

Among the above, from the viewpoint of compatibility with the thermoplastic resin (A3) and the monofunctional acrylate (B3) having a long chain alkyl group, at least one selected from the group consisting of the polyfunctional aliphatic (meth)acrylate compound and the polyfunctional alicyclic (meth)acrylate compound is preferable.

A mass-average molecular weight (Mw) of the polyfunctional (meth)acrylate (C3) is preferably 100 or more and 4,000 or less, more preferably 120 or more and 3,000 or less, still more preferably 120 or more and 2,000 or less, even more preferably 120 or more and 1,000 or less, even still more preferably 120 or more and 800 or less, and still further preferably 120 or more and 600 or less.

When the mass-average molecular weight (Mw) of the polyfunctional (meth)acrylate (C3) is within the above-described range, the molecular chains of the thermoplastic resin (A3), the monofunctional acrylate (B3) having a long chain alkyl group, and the polyfunctional (meth)acrylate (C3) are entangled with each other during curing, and the pseudo-crosslinking density is easily increased, so that the heat resistance of the sheet cured product to be obtained is favorable.

The polyfunctional (meth)acrylate (C3) has an ester group in the molecule, but it is preferable that such a polar functional group is small.

In addition, when the polyfunctional (meth)acrylate (C3) has a polar functional group as a substituent, it is preferable that the polar functional group is small in the same manner.

In a case where the polar functional group is small, the compatibility with the thermoplastic resin (A3) and the monofunctional acrylate (B3) having a long chain alkyl group is favorable, and the dielectric tangent of the sheet cured product to be obtained is also low.

The polar functional group means a functional group having a negative atom (for example, nitrogen, oxygen, chlorine, fluorine, and the like) and having a net dipole. For example, an ester group, a carbonyl group, a carboxyl group, a hydroxy group, an amide group, an amino group, and the like are exemplary examples.

A polar functional group equivalent of the polyfunctional (meth)acrylate (C3) (molecular weight of the polyfunctional (meth)acrylate (C3)/molecular weight of a polar functional group (when a plurality of polar functional groups, total amount thereof) is preferably 1.5 or more, more preferably 1.8 or more, still more preferably 2 or more, even more preferably 2.5 or more, and even still more preferably 3 or more.

### 3. Organic peroxide (D3)

The present composition (3) may contain an organic peroxide (D3) for the purpose of promoting a curing reaction.

As the above-described organic peroxide, for example, peroxides included in hydroperoxide, dialkyl peroxide, diacyl peroxide, peroxyester, and ketone peroxide groups are exemplary examples.

Specifically, hydroperoxides such as cumene hydroperoxide and tert-butyl hydroperoxide; dialkyl peroxides such as dicumyl peroxide, di-tert-butyl peroxide, 2,5-dimethyl-2,5-di(tert-butylperoxy)hexane, and 2,5-bis(tert-butylperoxy)-2,5-dimethyl-3-hexyne; diacyl peroxides such as lauryl peroxide and benzoyl peroxide; peroxyesters such as tert-butylperoxyacetate, tert-butylperoxybenzoate, and tert-butylperoxyisopropyl carbonate; and ketone peroxides such as cyclohexanone peroxide are exemplary examples.

A content of the organic peroxide (D3) in the present composition (3) is preferably 0.01 parts by mass or more and 5 parts by mass or less, more preferably 0.05 parts by mass or more and 3 parts by mass or less, and still more preferably 0.1 parts by mass or more and 1 part by mass or less with respect to 100 parts by mass of the thermoplastic resin (A3).

In a case where the content of the organic peroxide (D3) is within the above-described range, it is possible to maintain low dielectric characteristics of the sheet cured product while promoting the curing reaction.

### 4. Solvent (E3)

When the resin sheet is manufactured from the present composition (3) through a coating step, the present composition (3) may contain a solvent (E3).

The solvent (E3) is not particularly limited as long as the solvent (E3) is a solvent in which the thermoplastic resin (A3), the monofunctional (meth)acrylate (B3) having a long chain alkyl group, and the polyfunctional (meth)acrylate (C3) are uniformly dissolved, and toluene, cyclohexane, tetrahydrofuran, xylene, and the like are exemplary examples.

The solvent (E3) preferably has a boiling point of 200°C or lower so that the solvent (E3) volatilizes in a case where the resin sheet is dried.

From the viewpoint of film forming properties, a content of the solvent (E3) in the present composition (3) is preferably 100 parts by mass or more and 500 parts by mass or less, and more preferably 200 parts by mass or more and 400 parts by mass or less with respect to 100 parts by mass of the thermoplastic resin (A3).

### 5. Other components

The present composition (3) may contain, as a component other than the above-described components, a thermoplastic elastomer other than the thermoplastic resin (A3), a crosslinking agent other than the monofunctional (meth)acrylate (B3) having a long chain alkyl group and the polyfunctional (meth)acrylate (C3), an ultraviolet absorber, an antistatic agent, an antioxidant, a coupling agent, a plasticizer, a flame retardant, a colorant, a dispersant, an emulsifier, a low elastic agent, a diluent, an antifoaming agent, an ion trap agent, a thickener, a leveling agent, inorganic particles, organic particles, or the like.

As the crosslinking agent other than the monofunctional (meth)acrylate (B3) having a long chain alkyl group and the polyfunctional (meth)acrylate (C3), for example, a bismaleimide compound, an epoxy compound, and the like are exemplary examples.

As the inorganic particles, for example, calcium carbonate, magnesium carbonate, barium carbonate, magnesium sulfate, barium sulfate, calcium sulfate, zinc oxide, magnesium oxide, calcium oxide, titanium oxide, aluminum oxide, alumina, aluminum hydroxide, hydroxyapatite, silica, magnesium silicate, mica, talc, kaolin, clay, glass powder, asbestos powder, zeolite, white silica, and the like are exemplary examples.

As the organic particles, for example, (meth)acrylate-based resin particles, styrene-based resin particles, silicone-based resin particles, nylon-based resin particles, polyethylene-based resin particles, benzoguanamine-based resin particles, urethane-based resin particles, and the like are exemplary examples.

When containing inorganic particles or organic particles, a content thereof is preferably 1 part by mass or more and 80 parts by mass or less, more preferably 5 parts by mass or more and 75 parts by mass or less, and still more preferably 10 parts by mass or more and 70 parts by mass or less with respect to 100 parts by mass of the resin components of the present composition (3). When the content of the inorganic particles or the organic particles is the above-described lower limit value or more, the dielectric characteristics of the sheet cured product can be further lowered, the linear thermal expansion coefficient of the sheet cured product can be reduced, and when used as a circuit board material, peeling from a substrate is less likely to occur. On the other hand, in a case where the content of the inorganic particles or the organic particles is the above-described upper limit value or less, moldability of the sheet cured product is favorable.

### 6. Suitable aspects

As a combination of the thermoplastic resin (A3), the monofunctional (meth)acrylate (B3) having a long chain alkyl group, and the polyfunctional (meth)acrylate (C3) in the present composition (3), a combination of the styrene-based thermoplastic elastomer, the monofunctional (meth)acrylate having a linear, branched, or cyclic alkyl group having 8 or more and 25 or less carbon atoms, and at least one selected from the group consisting of a polyfunctional aliphatic (meth)acrylate compound, a polyfunctional alicyclic (meth)acrylate compound, a polyfunctional aromatic (meth)acrylate compound, and a polyfunctional heterocyclic (meth)acrylate compound is preferable; a combination of a styrene-isobutylene-styrene block copolymer (SIBS) or a styrene-ethylene-butadiene-styrene block copolymer (SEBS), the monofunctional (meth)acrylate having a linear, branched, or cyclic alkyl group having 8 or more and 25 or less carbon atoms, and at least one selected from the group consisting of a polyfunctional aliphatic (meth)acrylate compound, a polyfunctional alicyclic (meth)acrylate compound, a polyfunctional aromatic (meth)acrylate compound, and a polyfunctional heterocyclic (meth)acrylate compound is more preferable; a combination of a styrene-ethylene-butadiene-styrene block copolymer (SEBS), the monofunctional (meth)acrylate having a linear, branched, or cyclic alkyl group having 8 or more and 25 or less carbon atoms, and at least one selected from the group consisting of a polyfunctional aliphatic (meth)acrylate compound, a polyfunctional alicyclic (meth)acrylate compound, a polyfunctional aromatic (meth)acrylate compound, and a polyfunctional heterocyclic (meth)acrylate compound is still more preferable. In addition, a combination of the styrene-based thermoplastic elastomer, the monofunctional (meth)acrylate having a branched alkyl group having 8 or more and 25 or less carbon atoms, and at least one selected from the group consisting of a polyfunctional aliphatic (meth)acrylate compound and a polyfunctional alicyclic (meth)acrylate compound is preferable; a combination of a styrene-isobutylene-styrene block copolymer (SIBS) or a styrene-ethylene-butadiene-styrene block copolymer (SEBS), at least one selected from the group consisting of isodecyl (meth)acrylate, lauryl (meth)acrylate, tridecyl (meth)acrylate, and isostearyl (meth)acrylate, and at least one selected from the group consisting of a polyfunctional aliphatic (meth)acrylate compound and a polyfunctional alicyclic (meth)acrylate compound is more preferable; a combination of a styrene-ethylene-butadiene-styrene block copolymer (SEBS), at least one selected from the group consisting of isodecyl (meth)acrylate and isostearyl (meth)acrylate, and at least one selected from the group consisting of a polyfunctional aliphatic (meth)acrylate compound and a polyfunctional alicyclic (meth)acrylate compound is still more preferable; and a combination of a styrene-ethylene-butadiene-styrene block copolymer (SEBS), isostearyl (meth)acrylate, and at least one selected from the group consisting of a polyfunctional aliphatic (meth)acrylate compound and a polyfunctional alicyclic (meth)acrylate compound is particularly preferable.

### <Resin sheet>

The resin sheet according to one embodiment of the present invention (hereinafter, also referred to as "present resin sheet (3)") is obtained by molding the present composition (3) into a sheet shape in an uncured state.

A thickness of the present resin sheet (3) after curing is preferably 10 to 500 µm, more preferably 50 to 400 µm, and still more preferably 100 to 350 µm.

By setting the thickness of the present resin sheet (3) after curing to be the above-described lower limit value or more, handleability is favorable. In addition, by setting the thickness to be the above-described upper limit value or less, followability to steps of a substrate is favorable when the present resin sheet (3) is used as a circuit board material.

The above-described thickness is a value obtained by heat-pressing the present resin sheet (3) under conditions of 200°C and 0.2 MPa for 30 minutes to obtain a cured product, and measuring a thickness of the obtained cured product with a micrometer.

A specific dielectric constant of the present resin sheet (3) after curing is preferably 4 or less, more preferably 3 or less, and still more preferably 2.5 or less. On the other hand, the lower limit of the above-described specific dielectric constant is not particularly limited, and may be 1 or more.

In addition, a dielectric tangent of the present resin sheet (3) after curing is preferably 0.003 or less, more preferably 0.002 or less, and still more preferably 0.0015 or less. On the other hand, the lower limit of the above-described dielectric tangent is not particularly limited, and may be 0 or more.

The above-described specific dielectric constant and dielectric tangent are values obtained by heat-pressing the present resin sheet (3) under conditions of 200°C and 0.2 MPa for 30 minutes to obtain a cured product as a test piece, and measuring a specific dielectric constant and a dielectric tangent thereof in accordance with JIS C2565:1992 under conditions of a temperature of 23°C and a frequency of 10 GHz.

From the viewpoint of handleability, a storage elastic modulus of the present resin sheet (3) after curing (at 24°C) is preferably 1 MPa or more, more preferably 2 MPa or more, and still more preferably 3 MPa or more. In addition, when the present resin sheet (3) is used as a circuit board material, from the viewpoint of followability to steps of a substrate, the above-described storage elastic modulus (24°C) is preferably 1,000 MPa or less, more preferably 500 MPa or less, and still more preferably 300 MPa or less.

From the viewpoint of heat resistance, a storage elastic modulus of the present resin sheet (3) after curing (200°C) is preferably 0.01 MPa or more, more preferably 0.05 MPa or more, and still more preferably 0.1 MPa or more. The upper limit of the above-described storage elastic modulus (200°C) is not particularly limited, but is preferably 10 MPa or less and more preferably 5 MPa or less.

The above-described storage elastic modulus is a value obtained by heat-pressing the present resin sheet (3) under conditions of 200°C and 0.2 MPa for 30 minutes to obtain a cured product as a test piece, and measuring a dynamic viscoelasticity thereof.

From the viewpoint of heat resistance in a case of being mounted on a device, a heat resistance temperature of the present resin sheet (3) after curing is preferably 200°C or higher and 500°C or lower.

The above-described heat resistance temperature is a value obtained by heat-pressing the present resin sheet (3) under conditions of 200°C and 0.2 MPa for 30 minutes to obtain a cured product as a test piece, obtaining a graph by measuring a dynamic viscoelasticity thereof, and reading a temperature immediately before a rubbery flat region changes to a viscous liquid state.

### <Multilayer body>

In order to improve handleability, the present resin sheet (3) is preferably formed into a multilayer body by providing a release film on one or both surfaces thereof.

As the release film, for example, polyolefins such as polyethylene and polypropylene; polyesters such as polyethylene terephthalate and polyethylene naphthalate; polyimides; or resin films containing polycarbonate or the like as a main component can be used. A peel strength may be adjusted by coating surfaces of these films with a silicone resin release agent or the like.

A thickness of the release film is preferably 1 to 300 µm, more preferably 5 to 200 µm, still more preferably 10 to 150 µm, and even more preferably 20 to 120 µm.

In the release film, a surface which is brought into contact with the resin sheet may be subjected to a mat treatment, a corona treatment, or an antistatic treatment.

The above-described multilayer body may be wound around a core to form a wound body.

In the wound body according to the embodiment of the present invention, a length of the multilayer body is preferably 10 m or more and more preferably 20 m or more. By setting the length of the multilayer body to be 10 m or more, for example, when the present resin sheet (3) is used as a flexible laminated plate or a stretchable laminated plate, it is possible to continuously produce electronic components, resulting in excellent continuous film forming properties. The upper limit of the above-described length is not particularly limited, but is preferably 1,000 m or less.

A material of the core is not particularly limited, and for example, paper, resin-impregnated paper, an acrylonitrile/butadiene/styrene copolymer (ABS resin), a fiber-reinforced plastic (FRP), a phenol resin, an inorganic substance-containing resin, and the like are exemplary examples. An adhesive may be used for the core.

### <Manufacturing method of resin sheet>

Hereinafter, a manufacturing method of the present resin sheet (3) will be described, but the manufacturing method of the present resin sheet (3) is not limited to the following manufacturing method.

### [First manufacturing method]

A first manufacturing method of the present resin sheet (3) includes a coating liquid preparing step of preparing a coating liquid containing the resin composition, and a molding step of molding the coating liquid into a sheet shape.

In the coating liquid preparing step, a coating liquid is obtained by stirring and uniformly mixing the thermoplastic resin (A3), the monofunctional (meth)acrylate (B3) having a long chain alkyl group, the polyfunctional (meth)acrylate (C3), and the organic peroxide (D3), the solvent (E3), and other components, which are added as necessary.

Except for the above-described configuration, the process can be performed in the same manner as the first manufacturing method described in the first embodiment, and preferred conditions thereof are also the same.

### [Second manufacturing method]

A second manufacturing method of the present resin sheet (3) includes a film forming step of extruding the resin composition onto the release film.

In the film forming step, the thermoplastic resin (A3), the monofunctional (meth)acrylate (B3) having a long chain alkyl group, the polyfunctional (meth)acrylate (C3), and the organic peroxide (D3) and other components, which are added as necessary, are kneaded using a single-screw extruder or a twin-screw extruder, and film formation is performed by extruding the resin composition onto the release film using an extruder under a temperature condition which is a melting point of the thermoplastic resin (A3) or higher and lower than a crosslinking temperature of the monofunctional (meth)acrylate (B3) having a long chain alkyl group and the polyfunctional (meth)acrylate (C3). The extrusion method of the resin composition is not particularly limited, and more specifically, T-die molding is an exemplary example.

### <Sheet cured product>

The sheet cured product according to one embodiment of the present invention (hereinafter, also referred to as "present cured product (3)") is obtained by curing the present resin sheet (3).

A curing temperature of the present resin sheet (3) may be a temperature at which the thermoplastic resin (A3) does not flow and the crosslinking reaction of the monofunctional (meth)acrylate (B3) having a long chain alkyl group and the polyfunctional (meth)acrylate (C3) proceeds. Specifically, the curing temperature of the present resin sheet (3) is preferably 120°C to 300°C, more preferably 140°C to 250°C, and still more preferably 150°C to 220°C.

In addition, a curing time of the present resin sheet (3) is not particularly limited, but is preferably 10 minutes to 1 hour.

### <Applications of resin composition, resin sheet, and sheet cured product>

As applications of the present composition (3) of the above-described resin sheet according to the present invention, the present resin sheet (3), and the present cured product (3), for example, copper foil laminated plates, stretchable substrates, flexible printed circuit boards, multilayer printed wiring boards, circuit board materials for electrical and electronic equipment, such as a capacitor, underfill materials, interchip fill for 3D-LSI, insulating sheets, damping materials, adhesives agents, solder resists, semiconductor encapsulants, hole filling resins, component embedding resin, and the like are exemplary examples, but the present invention is not limited thereto.

### <Circuit board material>

In the same manner as the present resin sheet (1), the present resin sheet (3) according to one embodiment of the present invention can be formed into a circuit board material by being laminated with a conductor.

When used as a circuit board material for electrical and electronic equipment, a thickness of the present resin sheet (3) is preferably 10 µm or more and 500 µm or less. In addition, a thickness of the conductor is preferably 0.2 µm or more and 70 µm or less.

### <Manufacturing method of circuit board material>

The circuit board material including the present resin sheet (3) can be manufactured by, for example, the same method as the manufacturing method of the circuit board material including the present resin sheet (1).

The present resin sheet (3) according to one embodiment of the present invention is laminated on a conductor, and the present resin sheet (3) is thermally cured to form an insulating layer. A conductor is further laminated on the insulating layer, and a necessary number of such layers is laminated.

A curing temperature of the present resin sheet (3) may be a temperature at which the thermoplastic resin (A3) does not flow and the crosslinking reaction of the monofunctional (meth)acrylate (B3) having a long chain alkyl group and the polyfunctional (meth)acrylate (C3) proceeds. Specifically, the curing temperature of the resin sheet is preferably 120°C to 300°C, more preferably 140°C to 250°C, and still more preferably 150°C to 220°C.

In addition, a curing time of the present resin sheet (3) is not particularly limited, but is preferably 10 minutes to 1 hour.

### [Examples]

Hereinafter, the present invention will be described in more detail with reference to Examples, but the present invention is not limited by the present examples. In Examples and Comparative Examples described below, various physical properties were measured by the following methods.

### <Raw materials>

### [Thermoplastic resin (A1)]

· al-1: styrene-ethylene-butadiene-styrene block copolymer (SEBS: manufactured by Asahi Kasei E-Materials Corp., "Tuftec H1052"); styrene content: 20% by mass, storage elastic modulus (at 24°C) = 6.2 MPa, density = 0.890 g/cm³
· a1-2: styrene-ethylene-butadiene-styrene block copolymer (SEBS: manufactured by Asahi Kasei E-Materials Corp., "Tuftec H1051"); styrene content: 42% by mass, storage elastic modulus (at 24°C) = 270 MPa, density = 0.930 g/cm³
· a1-3: styrene-ethylene-butadiene-styrene block copolymer (SEBS: manufactured by Asahi Kasei E-Materials Corp., "Tuftec H1043"); styrene content: 67% by mass, storage elastic modulus (at 24°C) = 1,300 MPa, density = 0.970 g/cm³
· a1-4: styrene-ethylene-butadiene-styrene block copolymer (SEBS: manufactured by Asahi Kasei E-Materials Corp., "Tuftec M1943"); styrene content: 20% by mass, storage elastic modulus (at 24°C) = 6.8 MPa, density = 0.900 g/cm³

### [Vinyl-based crosslinking agent (B1)]

· b1-1: triallyl isocyanurate (TAlC: manufactured by Shinryo Corporation); mass-average molecular weight (Mw): 250
· b1-2: mixture of 57% of divinylbenzene, 40% of ethylvinylbenzene, and 3% of diethylbenzene (manufactured NIPPON STEEL Chemical & Material Co., Ltd., "DVB570"; mass-average molecular weight (Mw): 131
· b1-3: isostearyl acrylate (ISA: manufactured by SHIN-NAKAMURA CHEMICAL CO, LTD., "NK ESTER S-1800ALC"); mass-average molecular weight (Mw): 324.5, polar functional group (ester group) equivalent: 7.38
· b1-101: methyl acrylate (manufactured by TOKYO CHEMICAL INDUSTRY CO., LTD.); mass-average molecular weight (Mw): 86.09, polar functional group (ester group) equivalent: 1.96
· b1-102: triallyl isocyanurate (TAIC) which had been partially crosslinked; mass-average molecular weight (Mw): approximately 4,600

### (Production method)

TAIC (b1-1) was diluted with toluene so that a concentration of solid contents was 20% by mass to prepare a solution, and the solution was heated with a mantle heater at 200°C for approximately 7 minutes while extracting the solution each time not to boil the toluene. After the heating, as crude heat was taken off, the TAIC solution was immediately transferred to a freezer at 5°C to suppress a crosslinking reaction of TAlC. In a case where a molecular weight of TAIC after the heating was measured by gel permeation chromatography, and the molecular weight was calculated to be approximately 4,600.
· b1-103: triallyl isocyanurate (TAIC) which had been partially crosslinked; mass-average molecular weight (Mw): approximately 5,200

### (Production method)

A TAIC solution was produced by the same method as (b1-102), except that the heating was carried out with a mantle heater at 200°C for approximately 15 minutes. In a case where a molecular weight of TAIC after the heating was measured by gel permeation chromatography, and the molecular weight was calculated to be approximately 5,200.

### [Organic peroxide (C1)]

· cl-1: 2,5-bis(tert-butylperoxy)-2,5-dimethyl-3-hexyne (manufactured by NOF CORPORATION)

### [Solvent (D1)]

· d1-1: toluene (content: > 99.0% by mass)

### [Inorganic particles (E)]

. e1-1: micromica ("MK-100" manufactured by KATAKURA CHIKKARIN CO., LTD.); average particle diameter (D₅₀): 3 to 5 µm
· e1-2: plate-shaped alumina CeramNex ("AP10" manufactured by DIC CORPORATION); average particle diameter (D₅₀): 8 µm

### <Example 1>

Raw materials were blended in a proportion shown in Table 1, and heated at approximately 80°C to completely dissolve the raw materials to produce a resin composition. The produced resin composition was developed in a sheet shape on a release film having a thickness of 50 µm (PET film manufactured by Mitsubishi Chemical Corporation), which had been subjected to a silicone release treatment, to obtain a resin sheet. A thickness of the resin sheet was adjusted so that a thickness of a sheet after curing was approximately 300 µm.

The resin sheet developed on the release film was dried in an oven at 100°C for 1 hour, and a release film having a thickness of 50 µm (PET film manufactured by Mitsubishi Chemical Corporation), which had been subjected to a silicone release treatment, was laminated on the resin sheet such that a release-treated surface was on the resin sheet side to form a multilayer body. The multilayer body was held by a heat pressing machine at 200°C for 30 minutes while applying a pressure of approximately 0.2 MPa to completely cure the resin sheet, and the release films on both surfaces were peeled off to obtain a sheet cured product. The obtained sheet cured product was evaluated for dielectric characteristics, storage elastic modulus, and heat resistance temperature.

### <Examples 2 to 6 and Comparative Examples 1 to 6>

A sheet cured product was produced by the same method as in Example 1, except that the raw materials were blended according to a proportion shown in Table 1. The obtained sheet cured product was evaluated for dielectric characteristics, storage elastic modulus, and heat resistance temperature.

### <Measurement method>

### (1) Measurement of molecular weights of vinyl-based crosslinking agents (b1-102) and (b1-103)

Using a polystyrene-equivalent value measured by gel permeation chromatography, molecular weights of the crosslinking agents (b1-102) and (bl-103) were determined.

A measurement device and measurement conditions were as follows. Measurement device: "APC system" manufactured by Waters, Column: "ACQUITY APC XT column" (column size: 4.6 × 150 mm, pore size: 45) manufactured by Waters, measurement solvent: THF, column temperature: 40°C, flow cell temperature: 40°C, sample temperature: 20°C, flow rate: 0.7 L/min

### (2) Dielectric characteristics

A specific dielectric constant and a dielectric tangent of the sheet cured product in an in-plane direction were measured by TE mode using a cavity resonator (manufactured by AET, INC.) and a network analyzer MS46 122B (manufactured by ANRITSU CORPORATION). A measurement frequency was set to 10 GHz.

### (3) Storage elastic modulus and heat resistance temperature

A dynamic viscoelasticity of the sheet cured product was measured using a viscoelasticity spectrometer DVA-200 (manufactured by IT Keisoku Seigyo Co., Ltd.) under the following conditions. From the measurement results, values of storage elastic modulus at 24°C and 200°C were defined as the storage elastic modulus of each sheet cured product.

In addition, in the obtained graph of dynamic viscoelasticity, a temperature immediately before a rubbery flat region changed to a viscous liquid state was defined as the heat resistance temperature of each sheet.

### [Measurement conditions]

Vibration frequency: 10 Hz
Strain: 0.1%
Temperature rising rate: 3 °C/min
Measurement temperature: -100°C to 300°C

### (4) Linear thermal expansion coefficient

A linear thermal expansion coefficient of the sheet cured product was measured by thermomechanical analysis equipment with a method in accordance with JIS K7197 (2012). Specifically, using thermal analysis "TMA 841" (manufactured by METTLER TOLEDO), a sample shape was set to a width of 5 mm and a length of 16 mm, and measurement was started from 30°C up to 100°C at 5 °C/min. Thereafter, the sample was cooled to 0°C and re-heated up to 150°C, and a change in dimension in the re-heating process was measured. Based on this result, an average value of thermal expansion rates in an in-plane direction at 0°C to 120°C was calculated.

**[Table 1]**

| | | | Example 1 | Example 2 | Example 3 | Example 4 | Example 5 | Example 6 | Comparative Example 1 | Comparative Example 2 | Comparative Example 3 | Comparative Example 4 | Comparative Example 5 | Comparative Example 6 |
|---|---|---|---|---|---|---|---|---|---|---|---|---|---|---|
| Thermoplastic resin (A1) | | | | | | | | | | | | | | |
| | a1-1 | [part by mass] | 100 | 100 | - | - | 100 | 100 | 100 | 100 | 100 | 100 | 100 | 100 |
| | a1-2 | [part by mass] | - | - | 100 | - | - | - | - | - | - | - | - | - |
| | a1-3 | [part by mass] | - | - | - | 100 | - | - | - | - | - | - | - | - |

| Vinyl-based crosslinking agent (B1) | | | | | | | | | | | | | | |
|---|---|---|---|---|---|---|---|---|---|---|---|---|---|---|
| | b1-1 | [part by mass] | 15 | in | 15 | 15 | - | - | - | - | - | - | - | - |
| | b1-2 | [part by mass] | - | - | - | - | 15 | - | - | 30 | - | - | - | - |
| | b1-3 | [part by mass] | | - | - | - | - | 15 | - | - | 30 | - | - | - |
| | bl-101 | [part by mass] | - | | | - | - - | - | - | - | - | 15 | - | - |
| | b1-102 | [part by mass] | | | | | | | - | - | - | - | 15 | - |
| | b1-103 | [part by mass] | - | - | - | - | - | - | - | - | - | - | - | 15 |

| Organic peroxide (C1) | | | | | | | | | | | | | | |
|---|---|---|---|---|---|---|---|---|---|---|---|---|---|---|
| | c1-1 | [part by mass] | 0.5 | 0.5 | 0.5 | 0.5 | 0.5 | 0.5 | 0.5 | 0.5 | 0.5 | 0.5 | 0.5 | 0.5 |

| Solvent (D1) | | | | | | | | | | | | | | |
|---|---|---|---|---|---|---|---|---|---|---|---|---|---|---|
| | c1-1 | [part by mass] | 300 | 300 | 300 | 300 | 300 | 300 | 300 | 300 | 300 | 300 | 300 | 300 |

| Dielectric characteristics | | | | | | | | | | | | | | |
|---|---|---|---|---|---|---|---|---|---|---|---|---|---|---|
| Specific dielectric constant (10 GHz) | | [-] | 2.2 | 2.6 | 2.3 | 2.4 | 2.2 | 22 | 2.3 | 2.2 | 2.2 | 2.2 | 2.3 | 2.3 |
| Dielectric tangent (10 GHz) | | [-] | 0.0007 | 0.0006 | 0.0010 | 0.0015 | 0.0013 | 0.0020 | 0.0004 | 0.0005 | 0.0018 | 0.0013 | 0.0010 | 0.0011 |

| Storage elastic modulus | | | | | | | | | | | | | | |
|---|---|---|---|---|---|---|---|---|---|---|---|---|---|---|
| | 24°C | [MPa] | 9.0 | 7.0 | 300 | 1000 | 5.2 | 4.0 | 6.0 | 6.1 | 3.8 | 1700 | 6.4 | 5.7 |
| | 200°C | [MPa] | 0.7 | 0.4 | 1.0 | 0.2 | 0.3 | 0.2 | Flow | Flow | Flow | Flow | Flow | Flow |
| Heat resistance temperature | | [°C] | 220 | 220 | 290 | 210 | 210 | 210 | 110 | 105 | 95 | 125 | 126 | 142 |

From Examples 1 to 6, Comparative Example 1, and Comparative Examples 4 to 6, it was shown that, by adding the vinyl-based crosslinking agent (B1) having a mass-average molecular weight (Mw) of 100 or more and 4,000 or less to the thermoplastic resin (A1), the heat resistance could be improved while maintaining the low dielectric characteristics.

In Comparative Example 4 in which the mass-average molecular weight (Mw) of the vinyl-based crosslinking agent (B1) was smaller than 100, it was considered that, since the molecular chains of the vinyl-based crosslinking agent (B1) were short and were less likely to be entangled with the molecular chains of the thermoplastic resin (A1), the effect of increasing the pseudo-crosslinking density was less likely to be obtained.

In addition, in Comparative Examples 5 and 6 in which the mass-average molecular weight (Mw) of the vinyl-based crosslinking agent (B1) was more than 4,000, it was considered that, since the molecular chains of the vinyl-based crosslinking agent (B1) were too large and were less likely to be entangled with the molecular chains of the thermoplastic resin (A1), the effect of increasing the pseudo-crosslinking density was less likely to be obtained.

Moreover, from Examples 5 and 6 and Comparative Examples 2 and 3, it was shown that, when the content of the vinyl-based crosslinking agent (B1) was 30 parts by mass or more with respect to 100 parts by mass of the thermoplastic resin (A1), the heat resistance was decreased.

This is considered to be because, when the content of the vinyl-based crosslinking agent (B1) was large, the compatibility with the thermoplastic resin (A) was poor, and the effect of increasing the pseudo-crosslinking density was less likely to be obtained.

From Examples 1, 3, and 4, it was shown that, when the styrene-based thermoplastic elastomer was used as the thermoplastic resin (A1), the dielectric tangent was lowered as the styrene content was lower.

In addition, from Examples 1, 5, and 6, it was shown that, when the vinyl-based crosslinking agent (B1) did not have the polar functional group in the molecule or had a cyclic structure with a substituent not including the polar functional group, the dielectric tangent was lowered.

### <Examples 7 to 9>

A sheet cured product was produced by the same method as in Example 1, except that the raw materials were blended in a proportion shown in Table 2. The obtained sheet cured product was evaluated for dielectric characteristics, storage elastic modulus, heat resistance temperature, and linear thermal expansion coefficient.

**[Table 2]**

| | | | Example 7 | Example 8 | Example 9 |
|---|---|---|---|---|---|
| Thermoplastic resin (A1) | | | | | |
| | a1-4 | [part by mass] | 100 | 100 | 100 |

| Vinyl-based crosslinking agent (B1) | | | | | |
|---|---|---|---|---|---|
| | b1-1 | [part by mass] | 15 | 15 | 15 |

| Organic peroxide (C1) | | | | | |
|---|---|---|---|---|---|
| | c1-1 | [part by mass] | 0.5 | 0.5 | 0.5 |

| Solvent (D1) | | | | | |
|---|---|---|---|---|---|
| | e1-1 | [part by mass] | - | 50 | - |
| | e1-2 | [part by mass] | - | - | 150 |

| Dielectric characteristics | | | | | |
|---|---|---|---|---|---|
| | Specific dielectric constant (10 GHz) | [-] | 2.3 | 2.7 | 3.0 |
| | Dielectric tangent (10 GHz) | [-] | 0.0012 | 0.0011 | 0.0008 |

| Storage elastic modulus | | | | | |
|---|---|---|---|---|---|
| | 24°C | [MPa] | 11 | 30.0 | 180 |
| | 200°C | [MPa] | 1 | 2.4 | 21 |
| Heat resistance temperature | | [°C] | 300 | 210 | 250 |
| Linear thermal expansion coefficient | | [ppm/K] | 200 | 100 | 140 |

From Examples 7 to 9, it was shown that, by adding the inorganic particles, the dielectric tangent could be lowered and the linear thermal expansion coefficient could be also reduced.

In Examples described above, there was no example in which an olefin-based thermoplastic elastomer or an ethylene-based polymer was used as the thermoplastic resin (A1), but from the mechanism in which the heat resistance could be improved by the entanglement between the molecular chains of the thermoplastic resin (A1) and the molecular chains of the vinyl-based crosslinking agent (B1), the same effect as that of the styrene-based thermoplastic elastomer could be expected.

### <Raw materials>

### [Cyclic polyolefin resin copolymer (A2)]

· a2-1: "Tefabloc (registered trademark) CP CP402" manufactured by Mitsubishi Chemical Corporation was used as the cyclic polyolefin (A2)
· Crystal melting peak temperature: 75°C
· Dielectric tangent: 0.0008 (10 GHz)
· MFR (230°C, 2.16 kg): 85 g/10 min
· Hydrogenated aromatic vinyl polymer block unit: hydrogenated polystyrene having a content of 67 mol% and a hydrogenation level of 99% or more
· Hydrogenated conjugated diene polymer block unit: hydrogenated polybutadiene having a content of 33 mol% and a hydrogenation level of 99% or more
· Block structure: pentablock structure; total hydrogenation level: 99% or more
· Maleic acid-modified rate: 1.1% by mass
· Mw: 55,000

### [Thermoplastic resin (B2)]

· b2-1: styrene-ethylene-butadiene-styrene block copolymer (SEBS: manufactured by Asahi Kasei E-Materials Corp., "Tuftec H1052"); styrene content: 20% by mass, storage elastic modulus (at 24°C) = 6.2 MPa, density = 0.890 g/cm³

### [Vinyl-based crosslinking agent (C2)]

· c2-1: triallyl isocyanurate (TAlC: manufactured by Shinryo Corporation); mass-average molecular weight (Mw): 250

### [Organic peroxide (D2)]

· d2-1: 1,3-di(tert-butylperoxyisopropyl)benzene (manufactured by NOF CORPORATION)

### [Solvent (E2)]

· e2-1: toluene (content: > 99.0% by mass)

### <Example 11>

Raw materials were blended in a proportion shown in Table 3, and heated at approximately 80°C to completely dissolve the raw materials to produce a resin composition. The produced resin composition was developed in a sheet shape on a release film having a thickness of 50 µm (PET film manufactured by Mitsubishi Chemical Corporation), which had been subjected to a silicone release treatment, to obtain a resin sheet. A thickness of the resin sheet was adjusted so that a thickness of a sheet after curing was approximately 300 µm.

The resin sheet developed on the release film was dried in an oven at 100°C for 1 hour, and a release film having a thickness of 50 µm (PET film manufactured by Mitsubishi Chemical Corporation), which had been subjected to a silicone release treatment, was laminated on the resin sheet such that a release-treated surface was on the resin sheet side to form a multilayer body. The multilayer body was held by a heat pressing machine at 200°C for 30 minutes while applying a pressure of approximately 0.2 MPa to completely cure the resin sheet, and the release films on both surfaces were peeled off to obtain a sheet cured product. The obtained sheet cured product was evaluated for dielectric characteristics, solder heat resistance, and linear thermal expansion coefficient.

### <Examples 12 and 13, Comparative Example 11, and Reference Example 11>

A sheet cured product was produced by the same method as in Example 11, except that the raw materials were blended according to a proportion shown in Table 3. The obtained sheet cured product was evaluated for dielectric characteristics, solder heat resistance, and linear thermal expansion coefficient. In Comparative Example 11, the press conditions of the resin sheet were set to 200°C, approximately 0.2 MPa, and 2 minutes.

### <Measurement method>

### (1) Dielectric characteristics

A specific dielectric constant and a dielectric tangent of the sheet cured product in an in-plane direction were measured by TE mode using a cavity resonator (manufactured by AET, INC.) and a network analyzer MS46 122B (manufactured by ANRITSU CORPORATION). A measurement frequency was set to 10 GHz.

### (2) Solder heat resistance

A 2 cm square cut sheet sample was immersed in a melted solder bath at 260°C for 1 minute, and a change in state was observed. The sheet sample after immersing was visually confirmed and evaluated according to the following standard.
O (good): there was no change.
x (poor): large deformation or outflow of the resin was observed.

### (3) Linear thermal expansion coefficient

A linear thermal expansion coefficient of the sheet cured product was measured by thermomechanical analysis with a method in accordance with JIS K7197 (2012). Specifically, using a thermal analyzer "TMA 841" (manufactured by METTLER TOLEDO), a sample shape was set to a width of 5 mm and a length of 16 mm, and measurement was started from 30°C up to 100°C at 5 °C/min. Thereafter, the sample was cooled to 0°C and re-heated up to 150°C, and a change in dimension in the reheating process was measured. Based on this result, an average value of thermal expansion rates in an in-plane direction at 0°C to 120°C was calculated.

**[Table 3]**

| | | | Example 11 | Example 12 | Example 13 | Comparative Example 11 | Reference Example 11 |
|---|---|---|---|---|---|---|---|
| Cyclic polyolefin resin copolymer (A2) | | | | | | | |
| | a2-1 | [% by mass] | 20 | 50 | 70 | - | - |

| Thermoplastic resin (B2) | | | | | | | |
|---|---|---|---|---|---|---|---|
| | b2-1 | [% by mass] | 80 | 50 | 30 | 100 | 100 |

| Vinyl-based crosslinking agent (C2) | | | | | | | |
|---|---|---|---|---|---|---|---|
| | c2-1 | [phr] | 15 | 15 | 15 | - | 15 |

| Organic peroxide (D2) | | | | | | | |
|---|---|---|---|---|---|---|---|
| | d2-1 | [phr] | 1 | 1 | 1 | - | 1 |

| Solvent (E2) | | | | | | | |
|---|---|---|---|---|---|---|---|
| | e2-1 | [phr] | 300 | 300 | 300 | - | 300 |

| Dielectric characteristics | | | | | | | |
|---|---|---|---|---|---|---|---|
| | Specific dielectric constant (10 GHz) | [-] | 2.3 | 2.3 | 2.3 | 2.3 | 2.3 |
| | Dielectric tangent (10 GHz) | | 0.0006 | 0.0012 | 0.0015 | 0.0004 | 0.0006 |
| Solder heat resistance (260°C × 1 min) | | [-] | O | O | O | X | O |
| Average linear thermal expansion coefficient (0°C to 120°C) | | [ppm/°C] | 108 | 100 | 98 | 366 | 188 |

From Examples 11 to 13, it was shown that, by adding the vinyl-based crosslinking agent (C2) to the cyclic polyolefin resin copolymer (A2) and the thermoplastic resin (B2), the heat resistance could be improved while maintaining the low dielectric characteristics, and the linear thermal expansion coefficient could be also reduced.

On the other hand, from Comparative Example 11, it was shown that, when the thermoplastic resin (B2) was not cured by the vinyl-based crosslinking agent (C2), the solder heat resistance was not obtained, and the linear thermal expansion coefficient was also large.

In addition, from Reference Example 11, it was shown that, when the cyclic polyolefin resin copolymer (A2) was not contained, and the thermoplastic resin (B2) and the vinyl-based crosslinking agent (C2) were mixed to be cured, the solder heat resistance was obtained, but the linear thermal expansion coefficient was deteriorated as compared with Examples.

In Examples described above, there was no example in which an olefin-based thermoplastic elastomer or an ethylene-based polymer was used as the thermoplastic resin (B2), but from the mechanism in which the heat resistance could be improved by the entanglement between the molecular chains of the cyclic polyolefin resin copolymer (A2), the molecular chains of the thermoplastic resin (B2), and the molecular chains of the vinyl-based crosslinking agent (C2), and from the mechanism in which the linear thermal expansion coefficient could be reduced by relatively increasing the alicyclic structure due to the presence of the cyclic polyolefin resin copolymer (A2), the same effect as that of the styrene-based thermoplastic elastomer could be expected.

### <Raw materials>

### [Thermoplastic resin (A3)]

· a3-1: styrene-ethylene-butadiene-styrene block copolymer (SEBS: manufactured by Asahi Kasei E-Materials Corp., "Tuftec H1052"); styrene content: 20% by mass, storage elastic modulus (at 24°C) = 6.2 MPa, density = 0.890 g/cm³

### [Monofunctional (meth)acrylate (B3) having long chain alkyl group]

· b3-1: isostearyl acrylate (ISA: manufactured by SHIN-NAKAMURA CHEMICAL CO, LTD., "NK ESTER S-1800ALC"); mass-average molecular weight (Mw): 324.5, polar functional group (ester group) equivalent: 7.38
· b3-101: methyl acrylate (manufactured by TOKYO CHEMICAL INDUSTRY CO., LTD.); mass-average molecular weight (Mw): 86.09, polar functional group (ester group) equivalent: 1.96

### [Polyfunctional (meth)acrylate (C3)]

· c3-1: tetramethylolmethane tetraacrylate (TMMT: manufactured by SHIN-NAKAMURA CHEMICAL CO, LTD., "NK ESTER A-TMMT"); mass-average molecular weight (Mw): 352.34, polar functional group (ester group) equivalent: 2.00
· c3-2: tricyclodecane dimethanol diacrylate (A-DCP: manufactured by SHIN-NAKAMURA CHEMICAL CO, LTD., "NK ESTER A-DCP"); mass-average molecular weight (Mw): 336.48, polar functional group (ester group) equivalent: 3.82

### [Organic peroxide (D)]

· d3-1: 2,5-bis(tert-butylperoxy)-2,5-dimethyl-3-hexyne (manufactured by NOF CORPORATION)

### [Solvent (E3)]

· e3-1: toluene (content: > 99.0% by mass)

### <Example 21>

Raw materials were blended in a proportion shown in Table 4, and heated at approximately 80°C to completely dissolve the raw materials to produce a resin composition. The produced resin composition was developed in a sheet shape on a release film having a thickness of 50 µm (PET film manufactured by Mitsubishi Chemical Corporation), which had been subjected to a silicone release treatment, to obtain a resin sheet. A thickness of the resin sheet was adjusted so that a thickness of a sheet after curing was approximately 300 µm.

The resin sheet developed on the release film was dried in an oven at 100°C for 1 hour, and a release film having a thickness of 50 µm (PET film manufactured by Mitsubishi Chemical Corporation), which had been subjected to a silicone release treatment, was laminated on the resin sheet such that a release-treated surface was on the resin sheet side to form a multilayer body. The multilayer body was held by a heat pressing machine at 200°C for 30 minutes while applying a pressure of approximately 0.2 MPa to completely cure the resin sheet, and the release films on both surfaces were peeled off to obtain a sheet cured product. The obtained sheet cured product was evaluated for dielectric characteristics, storage elastic modulus, and heat resistance temperature.

### <Example 22 and Comparative Examples 21 to 24>

A sheet cured product was produced by the same method as in Example 21, except that the raw materials were blended according to a proportion shown in Table 4. The obtained sheet cured product was evaluated for dielectric characteristics, storage elastic modulus, and heat resistance temperature.

### <Measurement method>

### (1) Dielectric characteristics

A specific dielectric constant and a dielectric tangent of the sheet cured product in an in-plane direction were measured by TE mode using a cavity resonator (manufactured by AET, INC.) and a network analyzer MS46 122B (manufactured by ANRITSU CORPORATION). A measurement frequency was set to 10 GHz.

### (2) Storage elastic modulus and heat resistance temperature

A dynamic viscoelasticity of the sheet cured product was measured using a viscoelasticity spectrometer DVA-200 (manufactured by IT Keisoku Seigyo Co., Ltd.) under the following conditions. From the measurement results, values of storage elastic modulus at 24°C and 200°C were defined as the storage elastic modulus of each sheet cured product.

In addition, in the obtained graph of dynamic viscoelasticity, a temperature immediately before a rubbery flat region changed to a viscous liquid state was defined as the heat resistance temperature of each sheet.

### [Measurement conditions]

Vibration frequency: 10 Hz
Strain: 0.1%
Temperature rising rate: 3 °C/min
Measurement temperature: -100°C to 300°C

**[Table 4]**

| | | | Example 21 | Example 22 | Comparative Example 21 | Comparative Example 22 | Comparative Example 23 | Comparative Example 24 |
|---|---|---|---|---|---|---|---|---|
| Thermoplastic resin (A3) | | | | | | | | |
| | a3-1 | [part by mass] | 100 | 100 | 100 | 100 | 100 | 100 |

| Monofunctional acrylate (B3) | | | | | | | | |
|---|---|---|---|---|---|---|---|---|
| | b3-1 | [part by mass] | 8 | 8 | - | - | 9 | 15 |
| | b3-101 | [part by mass] | - | - | - | 8 | - | - |

| Polyfunctional acrylate (C3) | | | | | | | | |
|---|---|---|---|---|---|---|---|---|
| | c3-1 | [part by mass] | 7 | - | - | 7 | 21 | 15 |
| | c3-2 | [part by mass] | - | 7 | - | - | - | - |

| Organic peroxide (D3) | | | | | | | | |
|---|---|---|---|---|---|---|---|---|
| | d3-1 | [part by mass] | 0.5 | 0.5 | 0.5 | 0.5 | 0.5 | 0.5 |

| Solvent (E3) | | | | | | | | |
|---|---|---|---|---|---|---|---|---|
| | e3-1 | [part by mass] | 300 | 300 | 300 | 300 | 300 | 300 |

| Dielectric characteristics | | | | | | | | |
|---|---|---|---|---|---|---|---|---|
| | Specific dielectric constant (10 GHz) | [-] | 2.2 | 2.2 | 2.3 | 2.3 | 2.3 | 2.3 |
| | Dielectric tangent (10 GHz) | [-] | 0.0022 | 0.0017 | 0.0004 | 0.0031 | 0.0030 | 0.0035 |

| Storage elastic modulus | | | | | | | | |
|---|---|---|---|---|---|---|---|---|
| | 24°C | [MPa] | 8.1 | 7.0 | 6.0 | 4.8 | 7.4 | 13 |
| | 200°C | [MPa] | 0.76 | 0.45 | Flow | 1.0 | Plow | 0.20 |
| Heat resistance temperature | | [°C] | 220 | 220 | 110 | 225 | 120 | 220 |

From Examples 21 and 22 and Comparative Example 22, it was shown that, by adding the monofunctional (meth)acrylate (B) having a long chain alkyl group and the polyfunctional (meth)acrylate (C) to the thermoplastic resin (A), the heat resistance could be improved while maintaining the low dielectric characteristics.

In addition, from Examples 21 and 22 and Comparative Examples 23 and 24, it was shown that, when the total content of the monofunctional (meth)acrylate (B3) having a long chain alkyl group and the polyfunctional (meth)acrylate (C3) was 30 parts by mass or more with respect to 100 parts by mass of the thermoplastic resin (A3), the heat resistance was decreased.

This is considered to be because, when the total content of the monofunctional (meth)acrylate (B3) having a long chain alkyl group and the polyfunctional (meth)acrylate (C3) was large, the compatibility with the thermoplastic resin (A3) was poor, and the effect of increasing the pseudo-crosslinking density was less likely to be obtained.

From Examples 21 and 22, it was shown that the dielectric tangent was lowered as the number of polar functional groups in the molecule of the polyfunctional (meth)acrylate (C3) was smaller, that is, as the polar functional group equivalent of the polyfunctional (meth)acrylate (C3) (molecular weight of (C3)/molecular weight of polar functional group) was larger.

In Examples described above, there was no example in which an olefin-based thermoplastic elastomer or an ethylene-based polymer was used as the thermoplastic resin (A3), but from the mechanism in which the heat resistance could be improved by the entanglement between the molecular chains of the thermoplastic resin (A3), the molecular chains of the monofunctional (meth)acrylate (B3) having a long chain alkyl group, and the molecular chains of the polyfunctional (meth)acrylate (C3), the same effect as that of the styrene-based thermoplastic elastomer could be expected.

## Claims

1. A resin composition comprising:
at least one thermoplastic resin (A1) selected from the group consisting of a styrene-based thermoplastic elastomer, an olefin-based thermoplastic elastomer, and an ethylene-based polymer; and
a vinyl-based crosslinking agent (B1) having a mass-average molecular weight (Mw) of 100 or more and 4,000 or less,
wherein a content of the vinyl-based crosslinking agent (B1) is 1 part by mass or more and less than 30 parts by mass with respect to 100 parts by mass of the thermoplastic resin (A1).

2. The resin composition according to Claim 1,
wherein the thermoplastic resin (A1) includes the styrene-based thermoplastic elastomer.

3. The resin composition according to Claim 1,
wherein a styrene content of the styrene-based thermoplastic elastomer is 10% by mass or more and 70% by mass or less.

4. The resin composition according to Claim 1,
wherein the vinyl-based crosslinking agent (B1) includes at least one selected from the group consisting of a monofunctional aliphatic (meth)acrylate compound, a difunctional aromatic vinyl compound, and a trialkenyl isocyanurate compound.

5. The resin composition according to Claim 1,
wherein the vinyl-based crosslinking agent (B1) has no polar functional group in a molecule.

6. The resin composition according to Claim 1,
wherein a polar functional group equivalent of the vinyl-based crosslinking agent (B1) (a molecular weight of the vinyl-based crosslinking agent (B1)/a molecular weight of a polar functional group) is 2 or more.

7. The resin composition according to Claim 1, further comprising:
inorganic particles or organic particles.

8. A resin sheet formed of the resin composition according to any one of Claims 1 to 7.

9. A multilayer body comprising:
the resin sheet according to Claim 8; and
a release film provided one or both surfaces of the resin sheet.

10. A sheet cured product obtained by curing the resin sheet according to Claim 8.

11. A circuit board material comprising:
an insulating layer consisting of the resin sheet according to Claim 8; and
a conductor laminated on the insulating layer.

12. A resin sheet formed of a resin composition containing at least one thermoplastic resin (A1) selected from the group consisting of a styrene-based thermoplastic elastomer, an olefin-based thermoplastic elastomer, and an ethylene-based polymer, and a vinyl-based crosslinking agent (B1),
wherein a dielectric tangent of a cured product which is obtained by heat-pressing the resin sheet under conditions of 200°C and 0.2 MPa for 30 minutes is 0.003 or less, and
a storage elastic modulus of the cured product (at 200°C) is 0.01 MPa or more.

13. The resin sheet according to Claim 12,
wherein the vinyl-based crosslinking agent (B1) is contained in an amount of 1 part by mass or more and less than 30 parts by mass with respect to 100 parts by mass of the thermoplastic resin (A1).

14. The resin sheet according to Claim 12,
wherein a content of the thermoplastic resin (A1) in resin components of the resin composition is 60% by mass or more.

15. A resin composition comprising:
a cyclic polyolefin resin copolymer (A2) having a crystal melting peak temperature of lower than 100°C;
at least one thermoplastic resin (B2) selected from the group consisting of a styrene-based thermoplastic elastomer, an olefin-based thermoplastic elastomer, and an ethylene-based polymer; and
a vinyl-based crosslinking agent (C2).

16. The resin composition according to Claim 15,
wherein the cyclic polyolefin resin copolymer (A2) has cyclohexane in a side chain of a polyolefin.

17. The resin composition according to Claim 15,
wherein the cyclic polyolefin resin copolymer (A2) is a resin copolymer including at least one hydrogenated aromatic vinyl polymer block unit and at least one hydrogenated conjugated diene polymer block unit, or a modified product of the resin copolymer with at least one of an unsaturated carboxylic acid or an anhydride of the unsaturated carboxylic acid.

18. The resin composition according to Claim 17,
wherein a hydrogenation level of the hydrogenated aromatic vinyl polymer block unit is 90% or more.

19. The resin composition according to Claim 17,
wherein a hydrogenation level of the hydrogenated conjugated diene polymer block unit is 95% or more.

20. The resin composition according to Claim 15,
wherein the thermoplastic resin (B2) includes the styrene-based thermoplastic elastomer.

21. The resin composition according to Claim 15,
wherein a styrene content of the styrene-based thermoplastic elastomer is 10% by mass or more and 70% by mass or less.

22. The resin composition according to Claim 15,
wherein the vinyl-based crosslinking agent (C2) includes at least one selected from the group consisting of a monofunctional aliphatic (meth)acrylate compound, a difunctional aromatic vinyl compound, and a trialkenyl isocyanurate compound.

23. The resin composition according to Claim 15,
wherein the vinyl-based crosslinking agent (C2) has no polar functional group in a molecule.

24. The resin composition according to Claim 15,
wherein a polar functional group equivalent of the vinyl-based crosslinking agent (C2) (a molecular weight of the vinyl-based crosslinking agent (C2)/a molecular weight of a polar functional group) is 2 or more.

25. A resin sheet formed of the resin composition according to any one of Claims 15 to 24.

26. A multilayer body comprising:
the resin sheet according to Claim 25; and
a release film provided one or both surfaces of the resin sheet.

27. A sheet cured product obtained by curing the resin sheet according to Claim 25.

28. A circuit board material comprising:
an insulating layer consisting of the resin sheet according to Claim 25; and
a conductor laminated on the insulating layer.
